(19) **Europäisches Patentamt European Patent Office Office européen des brevets**

(11) **EP 4 481 964 A1**

(12) **EUROPEAN PATENT APPLICATION**
published in accordance with Art. 153(4) EPC

(43) Date of publication:
**25.12.2024 Bulletin 2024/52**

(21) Application number: **23752795.7**

(22) Date of filing: **03.02.2023**

(51) International Patent Classification (IPC):
**H01S 5/20** (2006.01)     **H01S 5/343** (2006.01)

(52) Cooperative Patent Classification (CPC):
**H01S 5/20; H01S 5/343**

(86) International application number:
**PCT/JP2023/003577**

(87) International publication number:
**WO 2023/153330 (17.08.2023 Gazette 2023/33)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.02.2022   JP 2022020107**

(71) Applicant: **Nuvoton Technology Corporation Japan**
**Nagaokakyo City, Kyoto 617-8520 (JP)**

(72) Inventors:
• **TAKAYAMA, Toru**
  **Nagaokakyo City, Kyoto 617-8520 (JP)**
• **YOSHIDA, Shinji**
  **Nagaokakyo City, Kyoto 617-8520 (JP)**
• **KAWAGUCHI, Yasutoshi**
  **Nagaokakyo City, Kyoto 617-8520 (JP)**
• **OKAGUCHI, Takahiro**
  **Nagaokakyo City, Kyoto 617-8520 (JP)**

(74) Representative: **Novagraaf International SA**
**Chemin de l'Echo 3**
**1213 Onex, Geneva (CH)**

(54) **NITRIDE-BASED SEMICONDUCTOR LIGHT-EMITTING ELEMENT**

(57)     A nitride semiconductor light-emitting element (100) includes: an N-type cladding layer (102); an N-side guide layer (103) disposed above the N-type cladding layer (102); an active layer (104) disposed above the N-side guide layer (103); a first P-side guide layer (105) disposed above the active layer (104); an electron barrier layer (106) disposed above the first P-side guide layer (105); a second P-side guide layer (107) disposed above the electron barrier layer (106); and a P-type cladding layer (108) disposed above the second P-side guide layer (107). An average band gap energy of the second P-side guide layer (107) is greater than an average band gap energy of the first P-side guide layer (105). An average band gap energy of the P-type cladding layer (108) is less than an average band gap energy of the electron barrier layer (106).

FIG. 9

EP 4 481 964 A1

**Description**

[Technical Field]

The present disclosure relates to a nitride semiconductor light-emitting element.

[Background Art]

Although nitride semiconductor light-emitting elements that emit blue light have been conventionally known, there has been a demand for a high-power nitride semiconductor light-emitting element that emits ultraviolet light having a shorter wavelength (see, for example, Patent Literature (PTL) 1). For example, when a nitride semiconductor light-emitting element makes it possible to achieve a watt-class ultraviolet laser light source, it is possible to use the nitride semiconductor light-emitting element for an exposure light source, a processing light source, etc.

[Citation List]

[Patent Literature]

[PTL 1] Japanese Unexamined Patent Application Publication No. 2014-131019

[Summary of Invention]

[Technical Problem]

An active layer including a quantum well structure, for example, is used as a light-emitting layer of a nitride semiconductor light-emitting element that emits ultraviolet light. Such an active layer includes one or more well layers and a plurality of barrier layers. Since ultraviolet light has a shorter wavelength (i.e., greater energy) than visible light, the band gap energy of a well layer that emits ultraviolet light is greater than the band gap energy of a well layer that emits visible light. For this reason, a difference between the conduction band potential energy and the electron quantum level energy of a barrier layer decreases. In this case, since electrons are likely to leak from a well layer into a P-side guide layer beyond the barrier layer, an operating carrier density (i.e., a carrier density when the nitride semiconductor element is in operation) in the well layer increases.

For example, when a nitride semiconductor light-emitting element is a laser element including a ridge that is a current injection region, an amplification gain in the current injection region of a well layer increases with an increase in operating carrier density. On the other hand, the refractive index of the well layer decreases with an increase in amplification gain in the well layer, based on a relation between the real part and imaginary part of a complex refractive index in the current injection region of the well layer (corresponding to the Kramers-Kronig relation). In addition, a refractive index in the current injection region of the well layer decreases with an increase in carrier density in the current injection region of the well layer due to a plasma effect. Accordingly, the refractive index of the current injection region of the well layer can be lower than the refractive index of the outside of the current injection region of the well layer. In this case, a waveguide structure for laser light that propagates through a waveguide including the ridge of the laser element becomes a gain waveguide structure of a refractive index anti-waveguide type. As a result, the proportion of a portion of the laser light that propagates through the outside of the current injection region of the well layer increases, and absorption loss in the well layer increases. Accordingly, the oscillation threshold current value of the laser element increases, and a thermal saturation level decreases. In other words, the temperature characteristics of the laser element deteriorate.

The present disclosure has been conceived to solve such a problem, and has an object to provide a nitride semiconductor light-emitting element having superior temperature characteristics.

[Solution to Problem]

In order to solve the above problem, a nitride semiconductor light-emitting element according to one aspect of the present disclosure comprising: an N-type cladding layer; an N-side guide layer disposed above the N-type cladding layer; an active layer disposed above the N-side guide layer; a first P-side guide layer disposed above the active layer; an electron barrier layer disposed above the first P-side guide layer; a second P-side guide layer disposed above the electron barrier layer; and a P-type cladding layer disposed above the second P-side guide layer, wherein an average band gap energy of the second P-side guide layer is greater than an average band gap energy of the first P-side guide layer, and an average band gap energy of the P-type cladding layer is less than an average band gap energy of the electron barrier layer.

[Advantageous Effects of Invention]

The present disclosure provides a nitride semiconductor light-emitting element having superior temperature characteristics.

[Brief Description of Drawings]

[FIG. 1]

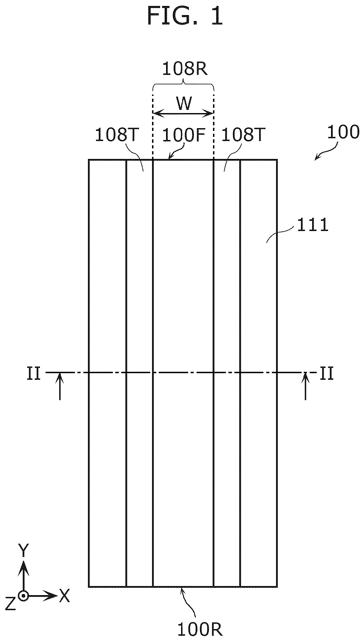

FIG. 1 is a schematic plan view of the overall configuration of a nitride semiconductor light-emitting element according to Embodiment 1.
[FIG. 2A]

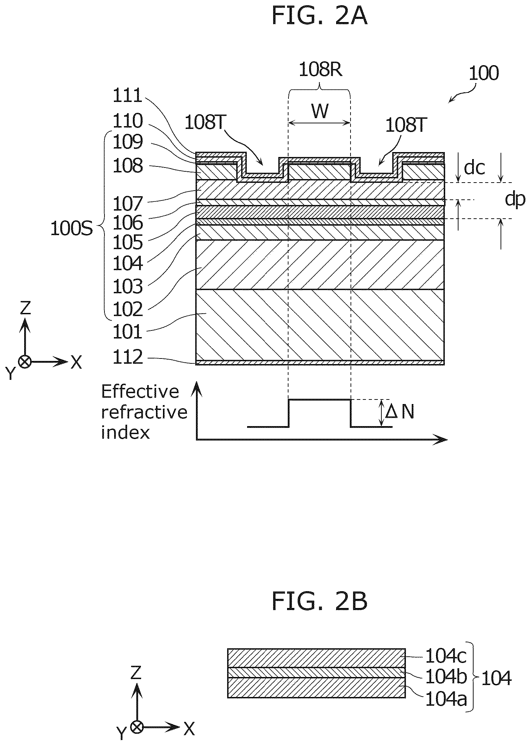

FIG. 2A is a schematic cross-sectional view of the overall configuration of the nitride semiconductor light-emitting element according to Embodiment 1.
[FIG. 2B]
FIG. 2B is a schematic cross-sectional view of the configuration of an active layer included in the nitride semiconductor light-emitting element according to Embodiment 1.
[FIG. 3]

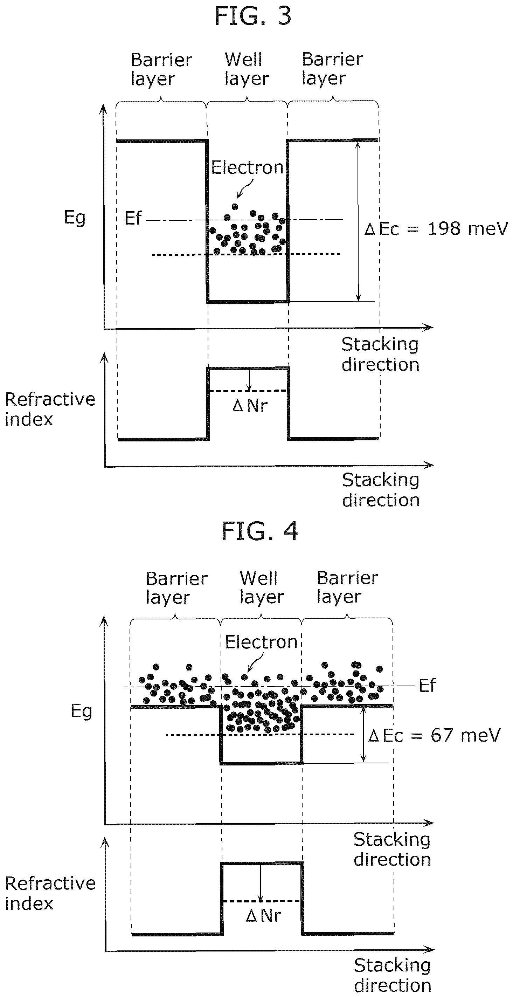

FIG. 3 is a graph showing a band gap energy distribution and a refractive index distribution in a stacking direction, in a well layer and a barrier layer of a semiconductor light-emitting element in a wavelength range including 405 nm.
[FIG. 4]
FIG. 4 is a graph showing a band gap energy distribution and a refractive index distribution in a stacking direction, in a well layer and a barrier layer of a semiconductor light-emitting element in a wavelength range including 375 nm.
[FIG. 5]

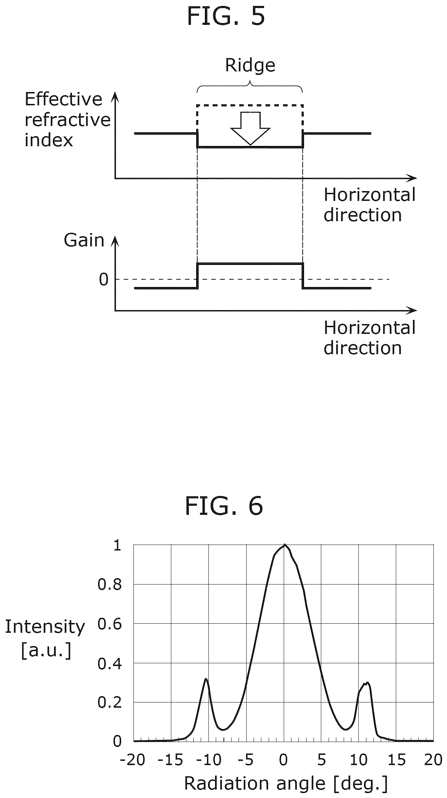

FIG. 5 is a graph showing an effective refractive index distribution and a gain distribution of the semiconductor light-emitting element in the wavelength range including 375 nm, in a horizontal direction.
[FIG. 6]
FIG. 6 is a graph showing a horizontal far-field pattern of a conventional ultraviolet semiconductor light-emitting element.
[FIG. 7]

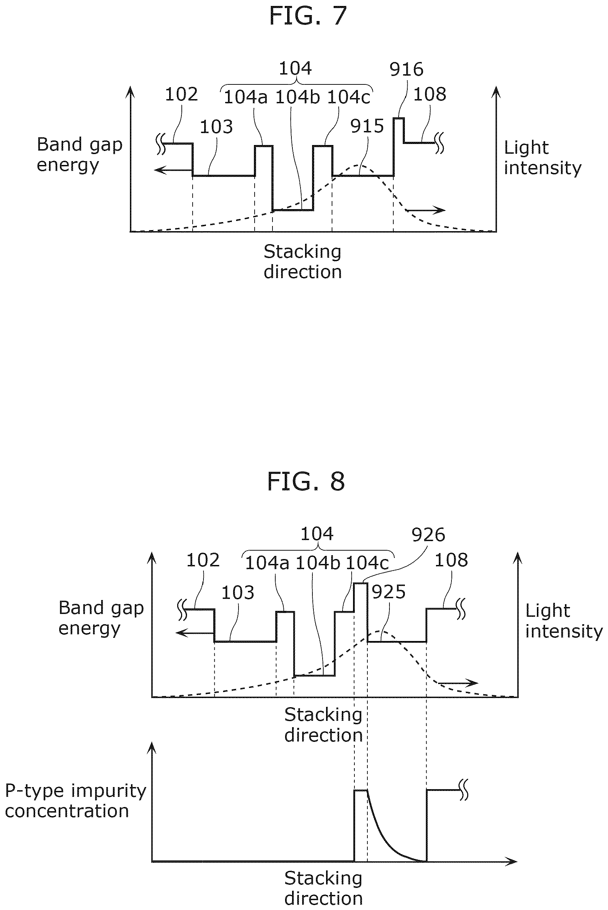

FIG. 7 is a graph schematically showing a band gap energy distribution and a light intensity distribution of a semiconductor stack according to Comparative Example 1, in a stacking direction.
[FIG. 8]
FIG. 8 is a graph schematically showing a band gap energy distribution and a light intensity distribution of a semiconductor stack according to Comparative Example 2, in a stacking direction.
[FIG. 9]

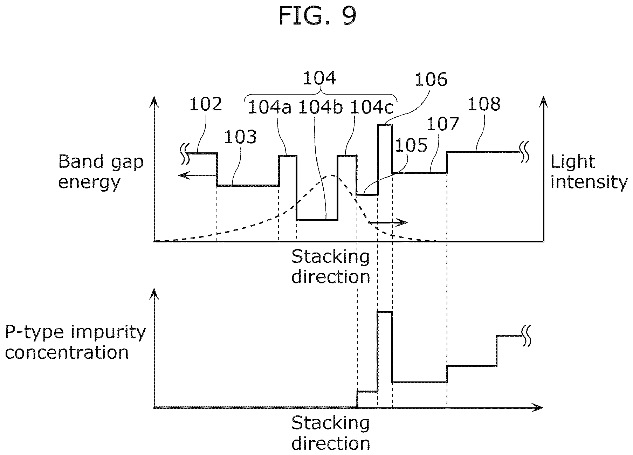

FIG. 9 is a graph schematically showing a band gap energy distribution and a light intensity distribution of a semiconductor stack according to Embodiment 1.
[FIG. 10]

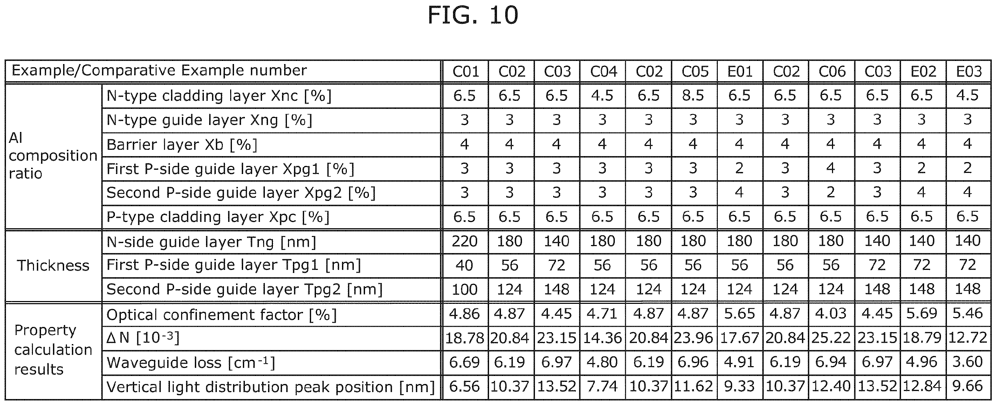

FIG. 10 is a table listing main configurations and property calculation results in Example E01 to Example E03 and Comparative Example C01 to Comparative Example C06.
[FIG. 11]

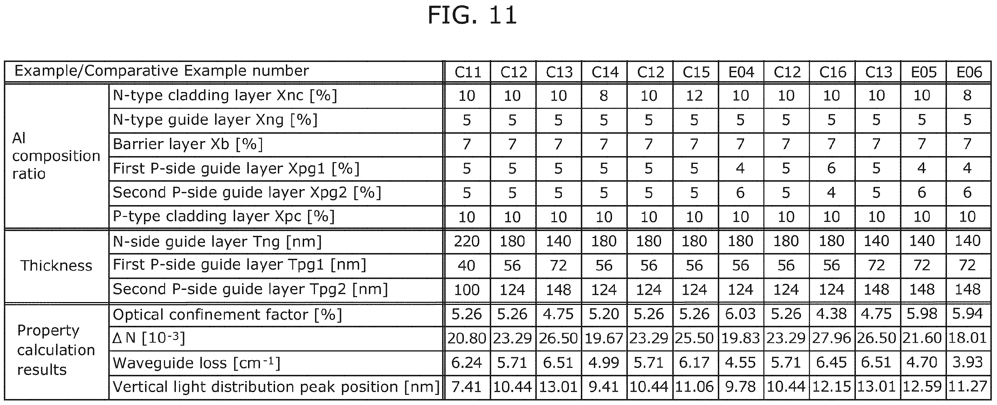

FIG. 11 is a table listing main configurations and property calculation results in Example E04 to Example E06 and Comparative Example C11 to Comparative Example C16.
[FIG. 12]

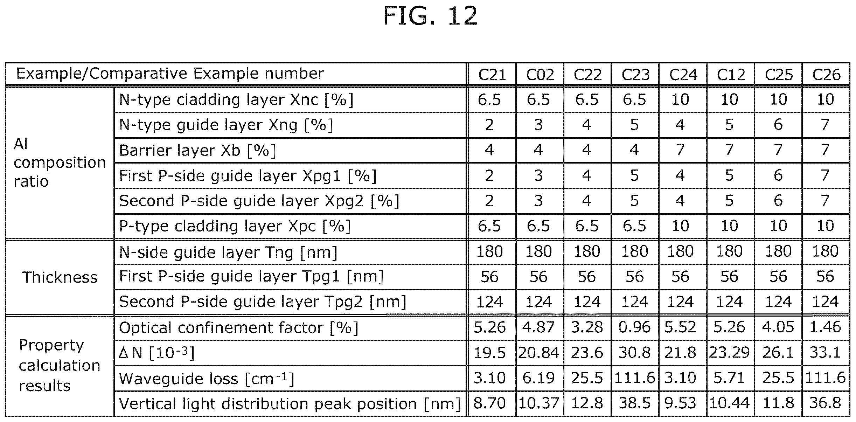

FIG. 12 is a table listing main configurations and property calculation results in Comparative Example C02, Comparative Example C12, and Comparative Example C21 to Comparative Example C26.
[FIG. 13]

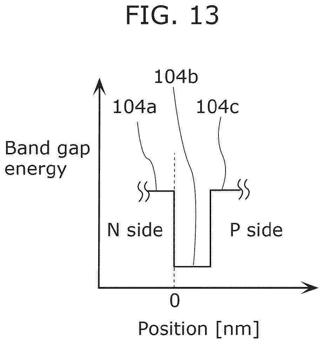

FIG. 13 is a graph showing the coordinates of positions in the nitride semiconductor light-emitting element according to Embodiment 1, in the stacking direction.
[FIG. 14]

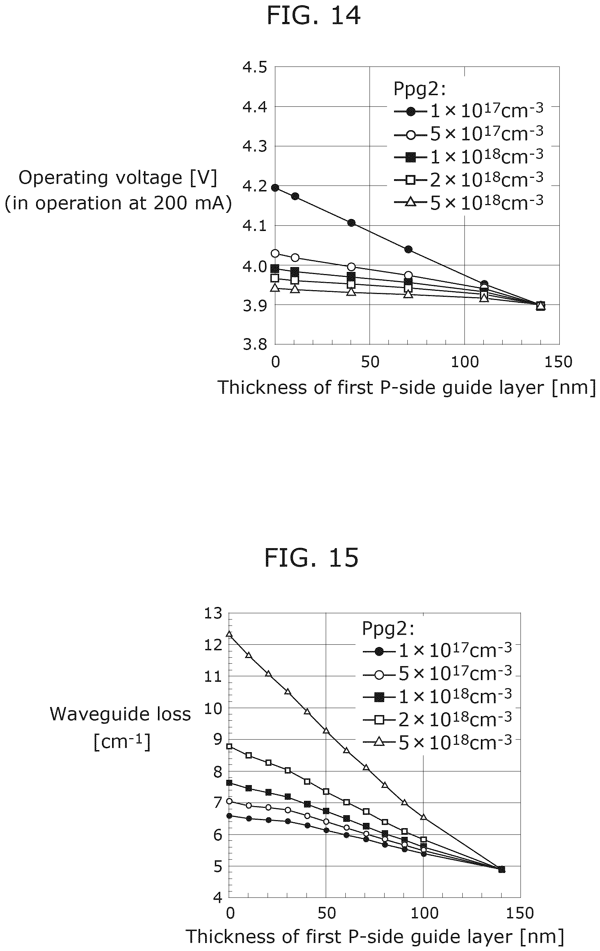

FIG. 14 is a graph showing a relation between an operating voltage when the nitride semiconductor light-emitting element according to Embodiment 1 is in operation at 200 mA and the thickness of a first P-side guide layer.
[FIG. 15]
FIG. 15 is a graph showing a relation between waveguide loss of the nitride semiconductor light-emitting element according to Embodiment 1 and the thickness of the first P-side guide layer.
[FIG. 16]

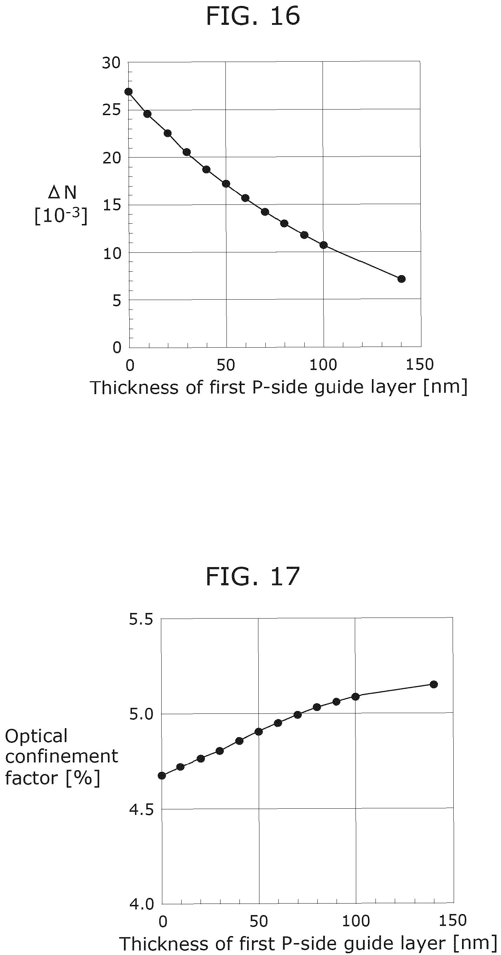

FIG. 16 is a graph showing a relation between effective refractive index difference $\Delta N$ of the nitride semiconductor light-emitting element according to Embodiment 1 and the thickness of the first P-side guide layer.

[FIG. 17]

FIG. 17 is a graph showing a relation between the optical confinement factor of the nitride semiconductor light-emitting element according to Embodiment 1 and the thickness of the first P-side guide layer.

[FIG. 18]

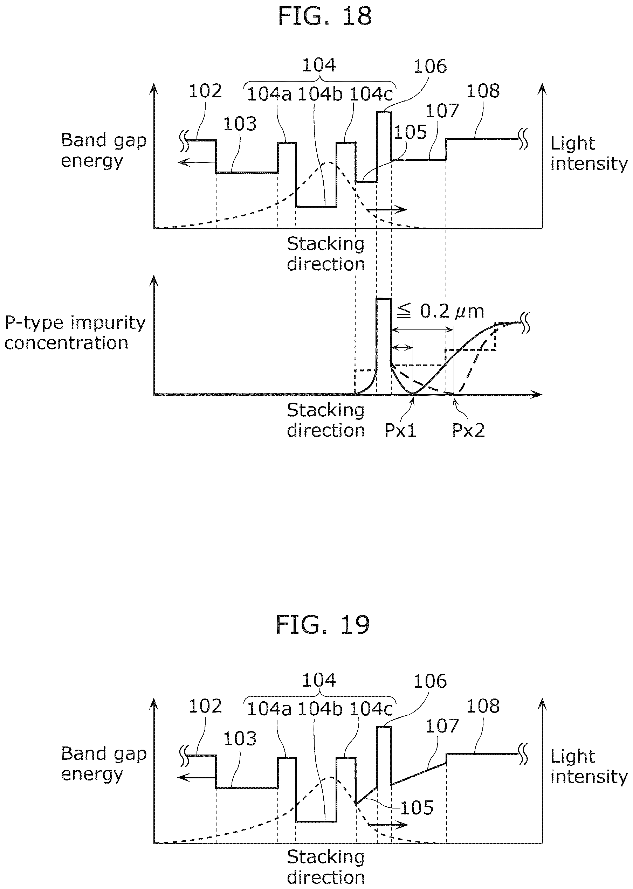

FIG. 18 is a graph schematically showing a band gap energy distribution and a light intensity distribution of a semiconductor stack in Example E02, in a stacking direction.

[FIG. 19]

FIG. 19 is a graph schematically showing a band gap energy distribution and a light intensity distribution of a semiconductor stack in Example E07, in a stacking direction.

[FIG. 20]

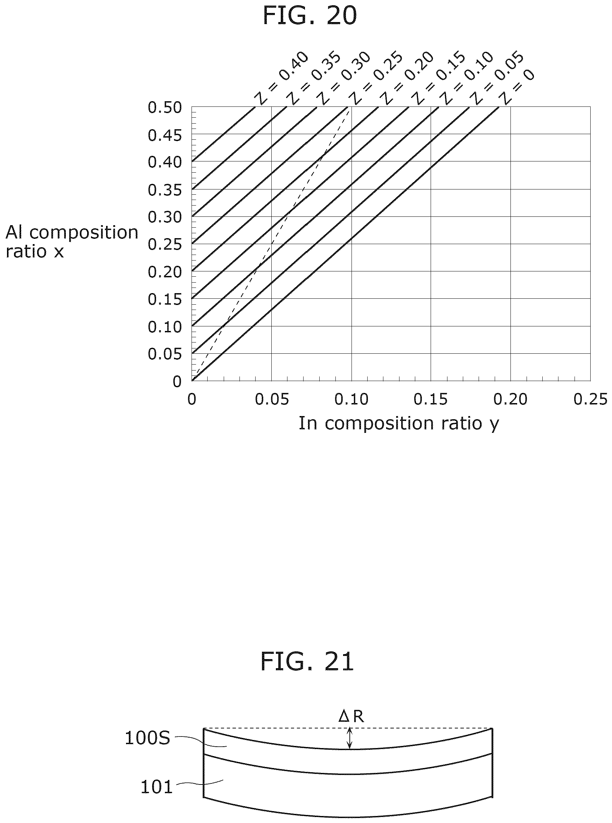

FIG. 20 is a graph showing a relation between band gap energy in an $Al_xGa_{1-x-y}In_yN$ layer and band gap energy in an $Al_zGa_{1-z}N$ layer.

[FIG. 21]

FIG. 21 is a schematic side view of the warp of a substrate according to Embodiment 1 and a semiconductor stack that occurs when the semiconductor stack is stacked on the substrate.

[FIG. 22]

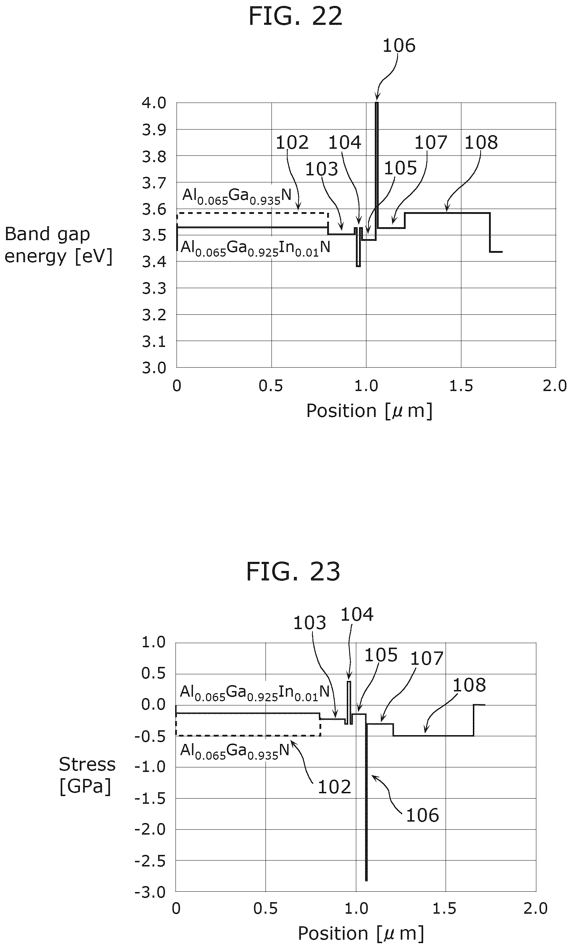

FIG. 22 is a graph showing a relation between a position and band gap energy in a semiconductor stack in Example E11 in a stacking direction.

[FIG. 23]

FIG. 23 is a graph showing a relation between a position and stress in the semiconductor stack in Example E11 in the stacking direction.

[FIG. 24]

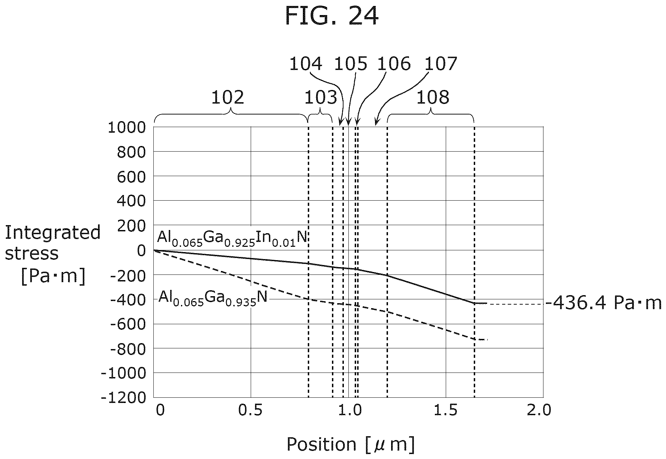

FIG. 24 is a graph showing a relation between a position and integrated stress in the semiconductor stack in Example E11 in the stacking direction.

[FIG. 25]

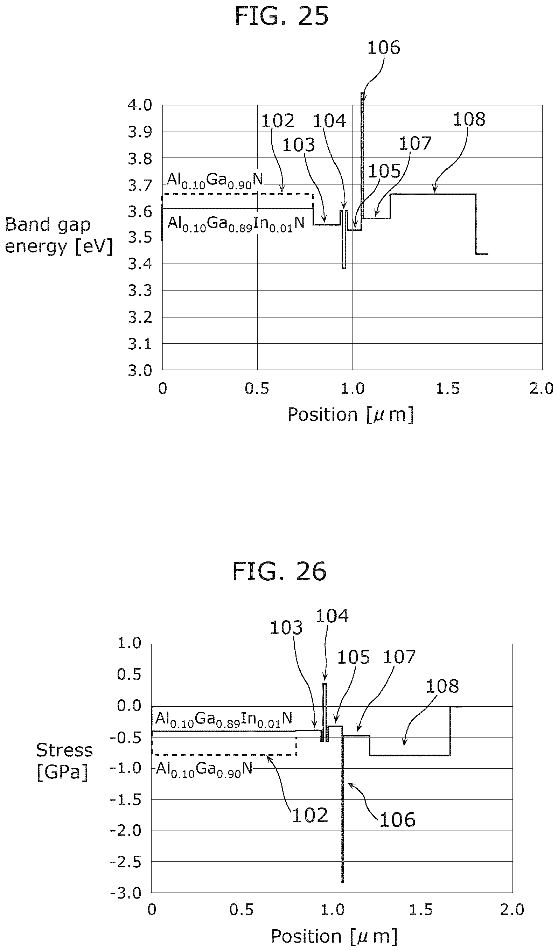

FIG. 25 is a graph showing a relation between a position and band gap energy in a semiconductor stack in Example E12 in a stacking direction.

[FIG. 26]

FIG. 26 is a graph showing a relation between a position and stress in the semiconductor stack in Example E12 in the stacking direction.

[FIG. 27]

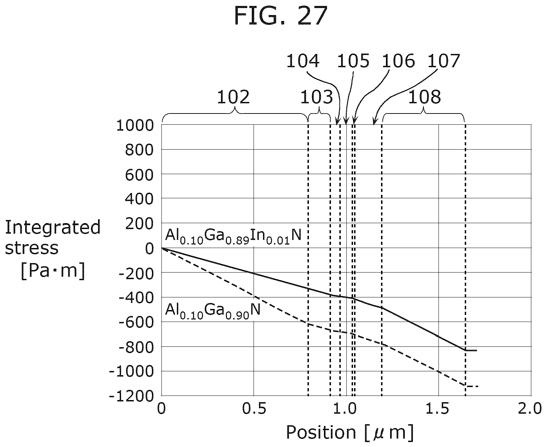

FIG. 27 is a graph showing a relation between a position and integrated stress in the semiconductor stack in Example E12 in the stacking direction.

[FIG. 28]

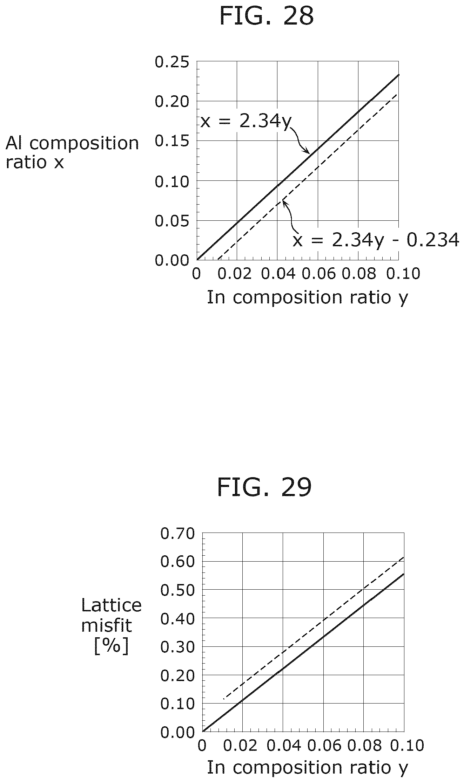

FIG. 28 is a graph for illustrating a composition required for a well layer in Example E13.

[FIG. 29]

FIG. 29 is a graph showing the In composition ratio of a well layer and lattice misfit with GaN.

[FIG. 30]

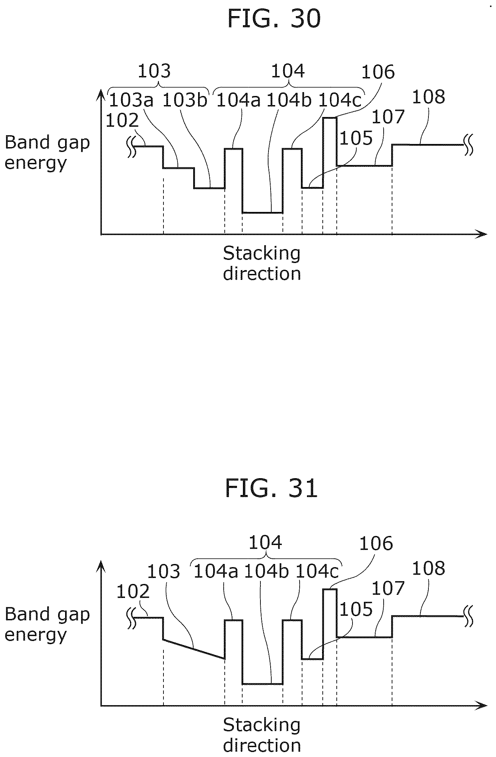

FIG. 30 is a graph schematically showing a band gap energy distribution of a semiconductor stack in Example E14 in a stacking direction.

[FIG. 31]

FIG. 31 is a graph schematically showing a band gap energy distribution of a semiconductor stack in Example E15 in a stacking direction.

[FIG. 32]

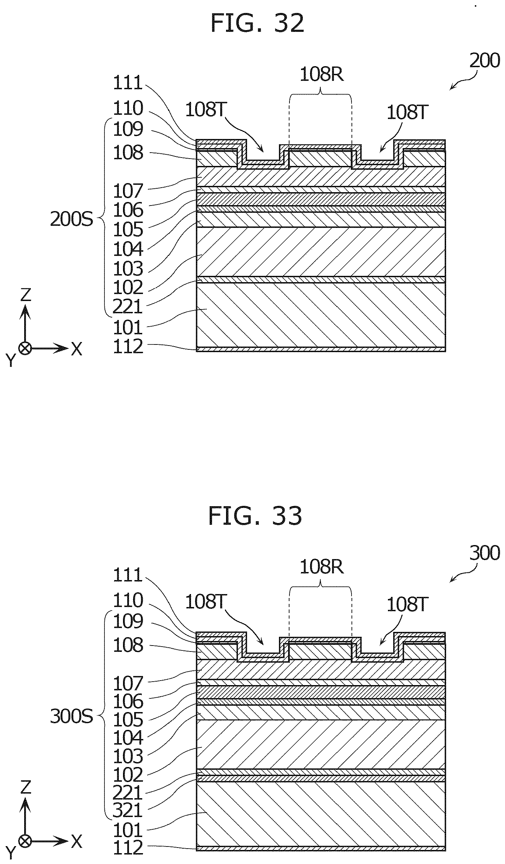

FIG. 32 is a schematic cross-sectional view of the overall configuration of a nitride semiconductor light-emitting element according to Embodiment 2.

[FIG. 33]

FIG. 33 is a schematic cross-sectional view of the overall configuration of a nitride semiconductor light-emitting element according to Embodiment 3.

[Description of Embodiments]

Hereinafter, embodiments of the present disclosure are described with reference to the drawings. It should be noted that the embodiments described below each show a specific example of the present disclosure. Accordingly, the numerical values, shapes, materials, constituent elements, the arrangement and connection of the constituent elements, etc. indicated in the following embodiments are mere examples, and are not intended to limit the present disclosure.

Moreover, the drawings are schematic drawings and are not necessarily precise illustrations. Accordingly, the figures are not necessarily to scale etc. It should be noted that, in the drawings, the same reference signs are assigned to substantially identical elements in the figures, and overlapping descriptions thereof are omitted or simplified.

Furthermore, in this Specification, the terms "above" and "below" do not refer to the upward (vertically upward) direction and downward (vertically downward) direction in terms of absolute spatial recognition, and are used as terms defined by relative positional relationships based on the stacking order of a stacked configuration. In addition, the terms "above" and "below" are applied not only when two constituent elements are arranged at intervals without another constituent element located between the two constituent elements, but also when two constituent elements are arranged adjacent to each other.

[Embodiment 1]

A nitride semiconductor light-emitting element according to Embodiment 1 is described below.

[1-1. Overall Configuration]

First, the overall configuration of the nitride semiconductor light-emitting element according to the present embodiment is described with reference to FIG. 1, FIG. 2A, and FIG. 2B. FIG. 1 and FIG. 2A are a schematic plan view and a schematic cross-sectional view of the overall configuration of nitride semiconductor light-emitting element 100 according to the present embodiment, respectively. FIG. 2A shows a cross section taken along line II-II in FIG. 1. FIG. 2B is a schematic cross-sectional view of the configuration of active layer 104 included in nitride semiconductor light-emitting element 100 according to the present embodiment. It should be noted that each of the figures shows an X axis, a Y axis, and a Z axis that are orthogonal to each other. The X axis, the Y axis, and the Z axis constitute a right-handed orthogonal coordinate system. The stacking direction of nitride semiconductor light-emitting element 100 is parallel to a Z-axis direction, and the main emission direction of light (laser light) is parallel to a Y-axis direction.

Nitride semiconductor light-emitting element 100 includes semiconductor stack 100S containing nitride semiconductor layers as shown in FIG. 2A, and emits light through end face 100F (see FIG. 1) in a direction perpendicular to the stacking direction of semiconductor stack 100S (i.e., the Z-axis direction). In the present embodiment, nitride semiconductor light-emitting element 100 is a semiconductor laser element that includes two end faces 100F and 100R that constitute a resonator. End face 100F is a front end face through which laser light is emitted, and end face 100R is a rear end face that has a higher reflectance than end face 100F. In addition, nitride semiconductor light-emitting element 100 includes a waveguide provided between end face 100F and end face 100R. In the present embodiment, end faces 100F and 100R have a reflectance of 16% and a reflectance of 95%, respectively. The resonator length of nitride semiconductor light-emitting element 100 according to the present embodiment (i.e., a distance between end face 100F and end face 100R) is approximately 1200 $\mu$m. Nitride semiconductor light-emitting element 100 emits, for example, ultraviolet light that has a peak wavelength in a wavelength range including 375 nm. It should be noted that nitride semiconductor light-emitting element 100 may emit ultraviolet light that has a peak wavelength in a band other than the wavelength range including 375 nm, or emit light having a peak wavelength in a wavelength range other than ultraviolet light.

As shown in FIG. 2A, nitride semiconductor light-emitting element 100 includes substrate 101, semiconductor stack 100S, current blocking layer 110, P-side electrode 111, and N-side electrode 112. Semiconductor stack 100S includes N-type cladding layer 102, N-side guide layer 103, active layer 104, first P-side guide layer 105, electron barrier layer 106, second P-side guide layer 107, P-type cladding layer 108, and contact layer 109.

Substrate 101 is a plate-shaped component that serves as a base for nitride semiconductor light-emitting element 100. In the present embodiment, substrate 101 is disposed below N-type cladding layer 102 and comprises N-type GaN. More specifically, substrate 101 is a GaN substrate that is doped with Si at a concentration of $1 \times 10^{18}$ cm$^{-3}$ and has a thickness of 8500 nm.

N-type cladding layer 102 is an N-type nitride semiconductor layer that is disposed above substrate 101. N-type cladding layer 102 has a lower refractive index and a greater average band gap energy than active layer 104. In the present embodiment, N-type cladding layer 102 comprises Al. In addition, the average Al composition ratio of N-type cladding layer 102 is lower than or equal to the average Al composition ratio of P-type cladding layer 108. N-type cladding layer 102 is doped with Si as impurities at a concentration of $5 \times 10^{17}$ cm$^{-3}$.

In the present disclosure, the average band gap energy of a layer refers to a band gap energy value that is obtained by (i) integrating, in the stacking direction of the layer, the amount of band gap energy at a position in the stacking direction from the position of an interface on a substrate side to the position of an interface farther from a substrate in the stacking direction and (ii) dividing the integrated amount of the band gap energy by the thickness of the layer (a distance between the interface on the substrate side and the interface farther from the substrate).

The average refractive index of a layer refers to a refractive index value that is obtained by (i) integrating, in the stacking direction of the layer, the magnitude of a refractive index at a position in the stacking direction from the position of an interface on a substrate side to the position of an interface farther from a substrate in the stacking direction and (ii) dividing the integrated magnitude of the refractive indexes by the thickness of the layer (a distance between the interface on the substrate side and the interface farther from the substrate).

The average Al composition ratio of a layer refers to an Al composition ratio value that is obtained by (i) integrating, in the stacking direction of the layer, the magnitude of an Al composition ratio at a position in the stacking direction from the position of an interface on a substrate side to the position of an interface farther from a substrate in the stacking direction and (ii) dividing the integrated magnitude of the al composition ratios by the thickness of the layer (a distance between the interface on the substrate side and the interface farther from the substrate).

The average impurity concentration of a layer refers to an average impurity concentration value that is obtained by (i) integrating, in the stacking direction of the layer, the magnitude of an impurity concentration at a position in the stacking direction from the position of an interface on a substrate side to the position of an interface farther from a substrate in the stacking direction and (ii) dividing the integrated magnitude of the impurity concentrations by the thickness of the layer (a distance between the interface on the substrate side and the interface farther from a substrate). For an N-type semiconductor layer, impurities refer to impurities used for doping to achieve an N conductivity type. For a P-type semiconductor layer, impurities refer to impurities used for doping to achieve a P conductivity type.

N-side guide layer 103 is a light guide layer that is disposed above N-type cladding layer 102 and includes a nitride semiconductor. N-side guide layer 103 has a higher refractive index and a less band gap energy than N-type cladding layer 102. In the present embodiment, the average band gap energy of N-side guide layer 103 is greater than the average band gap energy of first P-side guide layer 105, and is less than the average band gap energy of second P-side guide layer 107. N-side guide layer 103 comprises Al. In addition, N-side guide layer 103 is an undoped nitride semiconductor layer. In other words, the average N-type impurity concentration of N-side guide layer 103 is less than $1 \times 10^{18}$ cm$^{-3}$. It should be noted that, hereinafter, an N-type impurity concentration in each N-side layer and a P-type impurity concentration in each P-side layer are each also simply referred to as an impurity concentration.

Active layer 104 is a light-emitting layer that is disposed above N-side guide layer 103 and includes a nitride semiconductor. In the present embodiment, active layer 104 has a quantum well structure and emits ultraviolet light. Specifically, as shown in FIG. 2B, active layer 104 includes two barrier layers 104a and 104c and well layer 104b that is disposed between two barrier layers 104a and 104c. It should be noted that the configuration of active layer 104 is not limited to the above example. For example, active layer 104 may have a multiple quantum well structure. Specifically, active layer 104 may include three or more barrier layers and two or more well layers.

Barrier layers 104a and 104c are each a nitride semiconductor layer that is disposed above N-side guide layer 103 and serves as a barrier for the quantum well structure. Barrier layer 104c is disposed above barrier layer 104a. In the present embodiment, the band gap energy of each of barrier layers 104a and 104c is greater than the band gap energy of well layer 104b, the average band gap energy of first P-side guide layer 105, and the average band gap energy of N-side guide layer 103, and is less than the average band gap energy of electron barrier layer 106.

Well layer 104b is a nitride semiconductor layer that is disposed above barrier layer 104a and serves as a well in the quantum well structure.

First P-side guide layer 105 is a light guide layer that is disposed above active layer 104 and includes a nitride semiconductor. First P-side guide layer 105 has a higher refractive index and a less band gap energy than P-type cladding layer 108. In the present embodiment, first P-side guide layer 105 comprises Al. First P-side guide layer 105 is an undoped nitride semiconductor layer. In other words, the average impurity concentration of first P-side guide layer 105 is less than $1 \times 10^{18}$ cm$^{-3}$. The thickness of first P-side guide layer 105 is greater than the thickness of each of two barrier layers 104a and 104c. The thickness of first P-side guide layer 105 is less than the thickness of second P-side guide layer 107. In addition, the average band gap energy of first P-side guide layer 105 is less than the band gap energy of each of barrier layers 104a and 104c.

Electron barrier layer 106 is a nitride semiconductor layer that is disposed above first P-side guide layer 105. The band gap energy of electron barrier layer 106 is greater than the band gap energy of barrier layer 104c. This makes it possible to prevent electrons from leaking from active layer 104 into P-type cladding layer 108. In the present embodiment, the band gap energy of electron barrier layer 106 is greater than the band gap energy of P-type cladding layer 108.

Second P-side guide layer 107 is a light guide layer that is disposed above electron barrier layer 106 and includes a nitride semiconductor. Second P-side guide layer 107 has a higher refractive index and a less band gap energy than P-type cladding layer 108. In addition, the average band gap energy of second P-side guide layer 107 is greater than the band gap energy of first P-side guide layer 105. In the present embodiment, second P-side guide layer 107 comprises Al. Second P-side guide layer 107 is doped with impurities. In other words, the average impurity concentration of second P-side guide layer 107 is at least $1 \times 10^{18}$ cm$^{-3}$.

P-type cladding layer 108 is a cladding layer that is disposed above second P-side guide layer 107 and includes a P-type nitride semiconductor. P-type cladding layer 108 has a lower refractive index and a greater average band gap energy than active layer 104. The average band gap energy of P-type cladding layer 108 is less than the average band gap energy of electron barrier layer 106. In the present embodiment, P-type cladding layer 108 comprises Al. P-type cladding layer 108 is doped with Mg as impurities. The impurity concentration of an end portion of P-type cladding layer 108 closer to active layer 104 is lower than the impurity concentration of an end portion of P-type cladding layer 108 farther from active layer 104. Specifically, P-type cladding layer 108 is an AlGaN layer having a thickness of 450 nm, and includes: a P-type AlGaN layer that is disposed closer to active layer 104, doped with Mg at a concentration of $2 \times 10^{18}$ cm$^{-3}$, and has a thickness of 150 nm; and a P-type AlGaN layer that is disposed farther from active layer 104, doped with Mg at a concentration of $1 \times 10^{19}$ cm$^{-3}$, and has a thickness of 300 nm.

Ridge 108R is provided in P-type cladding layer 108. Additionally, two trenches 108T that extend along ridge 108R in the Y-axis direction are provided in P-type cladding layer 108. In the present embodiment, ridge width W is approximately 30 μm. Moreover, as shown in FIG. 2A, a distance between a lower end portion of ridge 108R (i.e., a bottom portion of trench 108T) and active layer 104 is denoted by dp. Furthermore, a distance between the lower end portion of ridge 108R and electron barrier layer 106 is denoted by dc.

Contact layer 109 is a nitride semiconductor layer that is disposed above P-type cladding layer 108 and in ohmic contact with P-side electrode 111. In the present embodiment, contact layer 109 is a P-type GaN layer having a thickness of 60 nm. Contact layer 109 is doped with Mg as impurities at a concentration of $1 \times 10^{20}$ cm$^{-3}$.

Current blocking layer 110 is an insulating layer that is disposed above P-type cladding layer 108 and is transmissive to light from active layer 104. Current blocking layer 110 is disposed in a region of the top faces of P-type cladding layer 108 and contact layer 109 other than the top face of ridge 108R. It should be noted that current blocking layer 110 may be disposed in a portion of a region of the top face of ridge 108R. For example, current blocking layer 110 may be disposed in an end edge region of the top face of ridge 108R. In the present embodiment, current blocking layer 110 is an SiO$_2$ layer.

P-side electrode 111 is a conductive layer that is disposed above contact layer 109. In the present embodiment, P-side electrode 111 is disposed above contact layer 109 and current blocking layer 110. P-side electrode 111 is, for example, a single-layer film or a multi-layer film that comprises at least one of Cr, Ti, Ni, Pd, Pt, Ag, or Au.

Since it is possible to minimize leakage of light propagating through a waveguide to P-side electrode 111 on contact layer 109 by using Ag having a low refractive index for light in a wavelength range including 375 nm for at least a portion of P-side electrode 111, it is possible to reduce waveguide loss that occurs in P-side electrode 111. Ag has a refractive index of at most 0.5 in a wavelength range from at least 325 nm to at most 1500 nm, and has a refractive index of at most 0.2 in a wavelength range from 360 nm to 950 nm. In this case, since it is possible to minimize the leakage of the light propagating through the waveguide to P-side electrode 111 even if P-type cladding layer 108 has a thickness of at most 0.4 μm, it is possible to inhibit an increase in waveguide loss while reducing series resistance of nitride semiconductor light-emitting element 100. As a result, it is possible to reduce an operating voltage and an operating current.

Here, in order to stably confine light propagating through the waveguide to ridge 108R, as will be described later, it is necessary to make an effective refractive index difference (ΔN) to cause the effective refractive index of an inner region of ridge 108R to be higher than the effective refractive index of an outer region of ridge 108R. Specifically, it is necessary to provide SiO$_2$ having a lower refractive index than P-type cladding layer 108 in a lateral wall of ridge 108R, and to reduce the effective refractive index of the outer region of ridge 108R. In this case, since a region in which SiO$_2$ is provided becomes smaller in the thickness direction of the lateral wall of ridge 108R when the thickness of P-type cladding layer 108 is excessively reduced, an effect of reducing the effective refractive index of the outer region of ridge 108R is reduced. For this reason, P-type cladding layer 108 needs to have a thickness of at least 0.15 μm.

N-side electrode 112 is a conductive layer that is disposed below substrate 101 (i.e., a principal surface opposite to a principal surface of substrate 101 above which N-type cladding layer 102 etc. is disposed). N-side electrode 112 is, for example, a single-layer film or a multi-layer film that comprises at least one of Cr, Ti, Ni, Pd, Pt, or Au.

Since nitride semiconductor light-emitting element 100 includes the above-described configuration, as shown in FIG. 2A, effective refractive index difference ΔN is made between an inner portion of ridge 108R and an outer portion of ridge 108R (a portion of trench 108T). This makes it possible to confine light that is generated in a portion of active layer 104 below ridge 108R to the horizontal direction (i.e., the X-axis direction).

[1-2. Problem with Ultraviolet Semiconductor Light-emitting Element]

The problem that can occur in an ultraviolet semiconductor light-emitting element, which is indicated in "Technical Problem" of the present disclosure, is described in detail with reference to FIG. 3 to FIG. 6. FIG. 3 is a graph showing a band gap energy (Eg) distribution and a refractive index distribution in a stacking direction, in a well layer and a barrier layer of a semiconductor light-emitting element in a wavelength range including 405 nm that has a longer wavelength than ultraviolet light. FIG. 4 is a graph showing a band gap energy (Eg) distribution and a refractive index distribution in a stacking direction, in a well layer and a barrier layer of a semiconductor light-emitting element in a wavelength range including 375 nm that is an ultraviolet region. FIG. 5 is a graph showing an effective refractive index distribution and a gain distribution of the semiconductor light-emitting element in the wavelength range including 375 nm, in the horizontal direction (corresponding to the X-axis direction in FIG. 1 to FIG. 2B). FIG. 6 is a graph showing a horizontal far-field pattern of a conventional ultraviolet semiconductor light-emitting element. The horizontal axis of FIG. 6 indicates a radiation angle in the horizontal direction, and the vertical axis of the same indicates a light intensity.

As shown in FIG. 3, in the semiconductor light-emitting element in the wavelength range including 405 nm, since the band gap energy of the well layer is relatively small, it is possible to set difference ΔEc between the conduction band potential energy and the electron quantum level energy of the barrier layer to be a relatively large value (198 meV). In this case, since Fermi energy Ef of electrons becomes sufficiently smaller than the conduction band potential energy of the barrier layer, it is possible to prevent the electrons from leaking from the well layer into a P-side semiconductor layer beyond the barrier layer.

In contrast, as shown in FIG. 4, in the ultraviolet semiconductor light-emitting element, since the band gap energy of the well layer is relatively large, difference ΔEc between the conduction band potential energy and the electron quantum level energy of the barrier layer is a small value (67 meV). In this case, since Fermi energy Ef of electrons can become larger than the conduction band potential energy of the barrier layer, the electrons are likely to leak from the well layer into a P-side semiconductor layer beyond the barrier layer. Accordingly, since carriers that are incapable of contributing to light emission in the well layer increase, an operating carrier density in the well layer increases.

When the operating carrier density in the well layer increases as above, the amplification gain of light in the well layer increases. On the other hand, the refractive index of the well layer decreases with an increase in amplification gain in the well layer, based on a relation between the real part and imaginary part of a complex refractive index in the current injection region of the well layer. In addition, a refractive index in the current injection region of the well layer decreases with an increase in carrier density in the current injection region of the well layer due to a plasma effect. Accordingly, the refractive index of the current injection region of the well layer can be lower than the refractive index of the outside of the current injection region of the well layer. For example, when the semiconductor light-emitting element is a laser element including a ridge and a current is injected into the ridge, as shown in FIG. 5, an effective refractive index in the ridge that is a current injection region can be lower than the effective refractive index of the outside of the current injection region.

For this reason, a waveguide structure for laser light that propagates through a waveguide that corresponds to the ridge of the semiconductor light-emitting element becomes a gain waveguide structure of a refractive index anti-waveguide type. As a result, the proportion of a portion of the laser light that propagates through the outside of the current injection region (a region located below the ridge) in the well layer increases, and peaks as shown in FIG. 6 occur in foot portions of the far field pattern of the semiconductor light-emitting element. In this case, since light is absorbed in the outside of the current injection region in the well layer, absorption loss in the well layer increases. Accordingly, the oscillation threshold current value of the semiconductor light-emitting element increases, and a thermal saturation level decreases. In other words, the temperature characteristics of the semiconductor light-emitting element deteriorate. Additionally, a portion that bends non-linearly (what is called a kink) can occur in a graph showing the current-light output (IL) characteristics of the semiconductor light-emitting element. To put it another way, the stability of the light output of the semiconductor light-emitting element deteriorates.

Nitride semiconductor light-emitting element 100 according to the present embodiment solves the problem with such an ultraviolet semiconductor light-emitting element.

[1-3. Light Intensity Distribution]

A light intensity distribution of nitride semiconductor light-emitting element 100 according to the present embodiment in the stacking direction is described in comparison with comparative examples, with reference to FIG. 7 to FIG. 9. FIG. 7 and FIG. 8 are each a graph schematically showing a band gap energy distribution and a light intensity distribution of a semiconductor stack according to each of Comparative Example 1 and Comparative Example 2, in the stacking direction. FIG. 9 is a graph schematically showing a band gap energy distribution and a light intensity distribution of semiconductor stack 100S according to the present embodiment. FIG. 8 and FIG. 9 each additionally show a P-type impurity concentration distribution of a semiconductor stack according to each of Comparative Example 2 and the present embodiment, in the stacking direction.

The semiconductor stack according to Comparative Example 1 shown in FIG. 7 includes N-type cladding layer 102, N-side guide layer 103, active layer 104, P-side guide layer 915, electron barrier layer 916, and P-type cladding layer 108. The semiconductor stack according to Comparative Example 1 differs from semiconductor stack 100S according to the present embodiment in the configuration of P-side guide layer 915. In the semiconductor stack according to Comparative Example 1, N-side guide layer 103 and P-side guide layer 915 have the same composition and thickness. In addition, electron barrier layer 916 is disposed between P-side guide layer 915 and P-type cladding layer 108.

In such a semiconductor stack according to Comparative Example 1, when N-type cladding layer 102 and P-type cladding layer 108 comprise AlGaN and have the same Al composition ratio, P-type cladding layer 108 has a higher refractive index than N-type cladding layer 102. This is because it is assumed that since the ionization energy of Mg that is a P-type impurity is greater than the ionization energy of Si that is an N-type impurity, it is necessary to set a P-type impurity concentration to be higher than an N-type impurity concentration, and thus a P-type layer that achieves a relatively deep energy level has greater light absorption and a higher refractive index. Accordingly, as shown in FIG. 7, the peak position of the light intensity distribution is shifted in a direction from active layer 104 toward P-type cladding layer 108. As a result, in the semiconductor stack according to Comparative Example 1, an optical confinement factor to active layer 104 decreases, and an operating carrier density increases. For this reason, the refractive index of well layer 104b decreases.

Moreover, as with nitride semiconductor light-emitting element 100 shown in FIG. 2A, for the semiconductor stack according to Comparative Example 1, effective refractive index difference ΔN depends on distance dp between a lower end portion of ridge 108R and active layer 104. Since the semiconductor stack according to Comparative Example 1 does not include second P-side guide layer 107, in order to put the peak position of the light intensity distribution in a vertical direction to the vicinity of active layer 104, it is necessary to increase the thickness of P-side guide layer 915 that has a higher refractive index than P-type cladding layer 108. For this reason, distance dp in the semiconductor stack according to Comparative Example 1 is greater than distance dp according to the present embodiment. Accordingly, effective refractive index difference ΔN of the semiconductor stack according to Comparative Example 1 is less than effective refractive index difference ΔN according to the present embodiment. As a result, in the semiconductor stack according to Comparative Example 1, the stability of a lateral mode of laser light during operation deteriorates.

The semiconductor stack according to Comparative Example 2 shown in FIG. 8 includes N-type cladding layer 102, N-side guide layer 103, active layer 104, electron barrier layer 926, P-side guide layer 925, and P-type cladding layer 108. The semiconductor stack according to Comparative Example 2 differs from the semiconductor stack according to Comparative Example 1 in the arrangement of electron barrier layer 926 and P-side guide layer 925. As shown in FIG. 8, in the semiconductor stack according to Comparative Example 2, the positions of electron barrier layer 926 and P-side guide layer 925 in the stacking direction are replaced with the positions of electron barrier layer 916 and P-side guide layer 915 in the stacking direction in the semiconductor stack according to Comparative Example 1.

Since electron barrier layer 926 is close to active layer 104 in such a semiconductor stack according to Comparative Example 2, compared with Comparative Example 1, distance dp from a lower end portion of ridge 108R to active layer 104 is less than distance dp according to Comparative Example 1. Accordingly, effective refractive index difference ΔN of the semiconductor stack according to Comparative Example 2 is greater than effective refractive index difference ΔN according to Comparative Example 1. As a result, the semiconductor stack according to Comparative Example 2 makes it possible to increase the stability of a lateral mode of laser light during operation, compared with Comparative Example 1. However, in the semiconductor stack according to Comparative Example 2, since electron barrier layer 926 having a high P-type impurity concentration is adjacent to active layer 104, a light intensity in electron barrier layer 926 increases. Since free carrier loss is huge in electron barrier layer 926 having the high P-type impurity concentration, waveguide loss increases in the semiconductor stack according to Comparative Example 2, compared with Comparative Example 1.

As shown in FIG. 9, semiconductor stack 100S according to the present embodiment includes first P-side guide 105 having a low band gap energy (i.e., a high refractive index) between active layer 104 and electron barrier layer 106. Moreover, the average band gap energy of first P-side guide layer 105 is less than the average band gap energy of second P-side guide layer 107, and the average refractive index of first P-side guide layer 105 is higher than the average refractive index of second P-side guide layer 107. Accordingly, semiconductor stack 100S according to the present embodiment makes it possible to move the peak position of the light intensity distribution closer to active layer 104 than the semiconductor stacks according to Comparative Example 1 and Comparative Example 2. Furthermore, since the average impurity concentration of first P-side guide layer 105 is less than $1 \times 10^{18}$ cm$^{-3}$ or, more specifically, first P-side guide layer 105 is a nitride semiconductor layer having an average impurity concentration of $7 \times 10^{17}$ cm$^{-3}$ (see FIG. 9), it is possible to reduce free carrier loss in first P-side guide layer 105. Accordingly, in the present embodiment, the free carrier loss decreases since the proportion of light in an undoped region in the vicinity of active layer 104 and first P-side guide layer 105 having a low impurity concentration increases in the light intensity distribution in the stacking direction, and it is possible to reduce the waveguide loss. For this reason, it is possible to decrease an oscillation threshold current value and a thermal saturation level. In other words, it is possible to achieve nitride semiconductor light-emitting element 100 having superior temperature characteristics and high slope efficiency. This allows high-temperature high-output operation in nitride semiconductor light-emitting element 100. Although FIG. 9 shows a case in which the impurity concentration of first P-side guide layer 105 is constant relative to the stacking direction, the impurity concentration may monotonically increase with increasing distance from active layer 104 in the stacking direction. In this case, since it is possible to cause the impurity concentration of a region of first P-side guide layer 105 close to active layer 104 having a high light intensity to be low relative to the impurity concentration of a region of first P-side guide layer 105 far from active layer 104, it is possible to reduce free carrier loss while inhibiting an increase in series resistance of nitride semiconductor light-emitting element 100.

It should be noted that second P-side guide layer 107 of semiconductor stack 100S according to the present embodiment is doped with impurities. Since this makes it possible to reduce the electrical resistance of semiconductor stack 100S, it is possible to reduce the operating voltage of nitride semiconductor light-emitting element 100. In addition, the light intensity in the vertical direction decreases since second P-side guide layer 107 is farther from active layer 104 than first P-side guide layer 105 is, and even if the average impurity concentration of second P-side guide layer 107 is caused to be higher than the average impurity concentration of first P-side guide layer 105, it is possible to reduce the free carrier loss in second P-side guide layer 107.

Moreover, in the present embodiment, distance dp is reduced by causing the thickness of first P-side guide layer 105 to be less than the thickness of second P-side guide layer 107. Accordingly, in the present embodiment, it is possible to increase effective refractive index difference $\Delta N$. Consequently, it is possible to increase the optical confinement factor of nitride semiconductor light-emitting element 100 to a waveguide. Since this makes it possible to stably confine the horizontal lateral mode of laser light to the waveguide in nitride semiconductor light-emitting element 100, it is possible to prevent kinks in current-light output characteristics from occurring. Furthermore, in the present embodiment, the total thickness of first P-side guide layer 105 and second P-side guide layer 107 is greater than or equal to the thickness of N-side guide layer 103. Since this makes it possible to further increase distance dc, it is possible to further increase effective refractive index difference $\Delta N$ and the optical confinement factor.

Moreover, in the present embodiment, the average band gap energy of second P-side guide layer 107 is caused to be greater than the average band gap energy of first P-side guide layer 105 by causing the average Al composition ratio of second P-side guide layer 107 to be higher than the average Al composition ratio of first P-side guide layer 105. Since this makes it possible to cause the average refractive index of first P-side guide layer 105 to be higher than the average refractive index of second P-side guide layer 107, it is possible to further move the peak position of the light intensity distribution closer to active layer 104. Accordingly, in the present embodiment, it is possible to reduce the waveguide loss of nitride semiconductor light-emitting element 100.

[1-4. Examples]

Examples of nitride semiconductor light-emitting element 100 according to the present embodiment are described in comparison to working examples, with reference to FIG. 10 to FIG. 13 etc. FIG. 10 is a table listing main configurations and property calculation results in Example E01 to Example E03 and Comparative Example C01 to Comparative Example C06. FIG. 11 is a table listing main configurations and property calculation results in Example E04 to Example E06 and Comparative Example C11 to Comparative Example C16. FIG. 12 is a table listing main configurations and property calculation results in Comparative Example C02, Comparative Example C12, and Comparative Example C21 to Comparative Example C26. It should be noted that for purpose of easy comparison between parameters and properties, FIG. 10 to FIG. 12 show the data of the same comparative examples in a plurality of cells (e.g., Comparative Example C02). FIG. 13 is a graph showing the coordinates of positions in nitride semiconductor light-emitting element 100 according to the present embodiment, in the stacking direction. As shown in FIG. 13, the coordinates of the position of the N-side end face of well layer 104b in active layer 104, that is, the end face of well layer 104b closer to N-side guide layer 103, are zero, with the downward direction (direction toward N-side guide layer 103) being the negative direction of coordinates and the upward direction (direction toward first P-side guide layer 105) being the positive direction of coordinates.

[1-4-1. Example E01]

Example E01 is described below. Nitride semiconductor light-emitting element 100 in Example E01 includes the following configuration (see FIG. 10). N-type cladding layer 102 is an N-type $Al_{0.065}Ga_{0.935}N$ layer that is doped with Si at a concentration of $5 \times 10^{17}$ cm$^{-3}$ and has a thickness of 800 nm. N-side guide layer 103 is an undoped $Al_{0.03}Ga_{0.97}N$ layer that has a thickness of 180 nm. Each of barrier layers 104a and 104c is an undoped $Al_{0.04}Ga_{0.96}N$ layer that has a thickness of 10 nm. Well layer 104b is an undoped $In_{0.01}Ga_{0.99}N$ layer that has a thickness of 17.5 nm. First P-side guide layer 105 is an undoped $Al_{0.02}Ga_{0.98}N$ layer that has a thickness of 56 nm. Electron barrier layer 106 is a P-type $Al_{0.36}Ga_{0.64}N$ layer that is doped with Mg at a concentration of $1 \times 10^{19}$ cm$^{-3}$ and has a thickness of 5 nm. Second P-side guide layer 107 is a P-type $Al_{0.04}Ga_{0.96}N$ layer that is doped with Mg at a concentration of $1 \times 10^{18}$ cm$^{-3}$ and has a thickness of 124 nm. P-type cladding layer 108 is a P-type $Al_{0.065}Ga_{0.935}N$ layer that has a thickness of 450 nm. P-type cladding layer 108 includes: a P-type $Al_{0.065}Ga_{0.935}N$ layer that is disposed closer to active layer 104, doped with Mg at a concentration of $2 \times 10^{18}$ cm$^{-3}$, and has a thickness of 150 nm; and a P-type $Al_{0.065}Ga_{0.935}N$ layer that is disposed farther from active layer 104, doped with Mg at a concentration of $1 \times 10^{19}$ cm$^{-3}$, and has a thickness of 300 nm. Contact layer 109 is a P-type GaN layer that is doped with Mg at a concentration of $1 \times 10^{10}$ cm$^{-3}$ and has a thickness of 100 nm

It should be noted that configurations not shown in FIG. 10 among the configurations in Comparative Examples C01 to C06 are the same as the configurations in Example E01. For example, nitride semiconductor light-emitting elements in Comparative Example C02 and Comparative Example C06 differ from Example E01 in the Al composition ratio (Xpg1) of a first P-side guide layer and the Al composition ratio (Xpg2) of a second P-side guide layer, and are identical to Comparative Example E01 in the other configurations. In Comparative Example C02, since the first P-side guide layer and the second P-side guide layer are identical in composition, the average band gap energy of the second P-side guide layer is equal to the average band gap energy of the first P-side guide layer. In addition, in the nitride semiconductor light-emitting element in Comparative Example C06, since the Al composition ratio of the second P-side guide layer is lower than the Al composition ratio of the first P-side guide layer, the average band gap energy of the second P-side guide layer is less than the average band gap energy of the first P-side guide layer.

On the other hand, in nitride semiconductor light-emitting element 100 according to Example E01, since the Al composition ratio of second P-side guide layer 107 is higher than the Al composition ratio of first P-side guide layer 105, the average band gap energy of second P-side guide layer 107 is greater than the average band gap energy of first P-side guide layer 105. A comparison of the property calculation results between Example E01, Comparative Example C02, and Comparative Example C06 shown in FIG. 10 clearly shows that in Example E01, since the proportion of light located in an undoped region in the vicinity of active layer 104 and first P-side guide layer 105 having a low impurity concentration increases in the light distribution in the stacking direction due to the average band gap energy of second P-side guide layer 107 being greater than the average band gap energy of first P-side guide layer 105 (i.e., the refractive index of first P-side guide layer 105 being higher than the refractive index of second P-side guide layer 107), it is possible to increase an optical confinement factor and reduce waveguide loss.

Next, the thickness (Tpg1) of first P-side guide layer 105 and an impurity concentration (Ppg2) in second P-side guide layer 107 are described with reference to FIG. 14 to FIG. 17. FIG. 14 and FIG. 15 are a graph showing a relation between an operating voltage when nitride semiconductor light-emitting element 100 according to Embodiment 1 is in operation at 200 mA and the thickness of first P-side guide layer 105, and a graph showing a relation between waveguide loss and the thickness of first P-side guide layer 105, respectively. In FIG. 14 and FIG. 15, the total thickness of first P-side guide layer 105 and second P-side guide layer 107 of nitride semiconductor light-emitting element 100 according to Comparative Example C01 is 140 nm. FIG. 14 and FIG. 15 show the operating voltage and the waveguide loss when the thickness of first P-side guide layer 105 is changed, respectively. Additionally, FIG. 14 and FIG. 15 show the operating voltage and the waveguide loss when an average impurity concentration (an average Mg concentration) in second P-side guide layer 107 is changed from $1 \times 10^{17}$ cm$^{-3}$ to $5 \times 10^{18}$ cm$^{-3}$, respectively. FIG. 16 is a graph showing a relation between effective refractive index difference $\Delta$N of nitride semiconductor light-emitting element 100 according to the present embodiment and the thickness of first P-side guide layer 105. FIG. 17 is a graph showing a relation between the optical confinement factor of nitride semiconductor light-emitting element 100 according to the present embodiment and the thickness of first P-side guide layer 105.

As shown in FIG. 14, it is possible to reduce the operating voltage by causing the average impurity concentration of second P-side guide layer 107 to be at least $5 \times 10^{17}$ cm$^{-3}$. As shown in FIG. 15, it is possible to reduce the waveguide loss by causing the average impurity concentration of second P-side guide layer 107 to be at most $2 \times 10^{18}$ cm$^{-3}$. Accordingly, it is possible to reduce both the operating voltage and the waveguide loss by causing the average impurity concentration of second P-side guide layer 107 to be at least $5 \times 10^{17}$ cm$^{-3}$ and at most $2 \times 10^{18}$ cm$^{-3}$. In addition, it is possible to further reduce the waveguide loss by causing the average impurity concentration of second P-side guide layer 107 to be at most $1 \times 10^{18}$ cm$^{-3}$.

As shown in FIG. 14 and FIG. 17, the operating voltage is reduced and an optical confinement factor increases with an increase in thickness of first P-side guide layer 105. In contrast, as shown in FIG. 16, effective refractive index difference $\Delta$N increases with a decrease in thickness of first P-side guide layer 105 (i.e., an increase in thickness (Tpg2) of second P-side guide layer 107). However, since electron barrier layer 106 that has a high Al composition ratio and a low refractive index is brought closer to active layer 104 when the thickness of first P-side guide layer 105 is decreased, the optical confinement factor decreases.

In view of this, as shown in Example E01, it is possible to increase the optical confinement factor by setting the Al composition ratio of first P-side guide layer 105 to be lower than the Al composition ratio of second P-side guide layer 107, that is, causing the refractive index of first P-side guide layer 105 to be high relative to second P-side guide layer 107. A structure in Example E01 that has adopted such a configuration makes it possible to increase the optical confinement factor up to 5.65%, whereas a structure in Comparative Example C01 has an optical confinement factor of 4.86%.

Moreover, as shown in FIG. 14, the structure in Example E01 makes it possible to reduce the operating voltage by causing the average impurity concentration of second P-side guide layer 107 to be at least $5 \times 10^{17}$ cm$^{-3}$. Furthermore, as shown in FIG. 15, the structure in Example E01 makes it possible to reduce the waveguide loss by causing the average impurity concentration of second P-side guide layer 107 to be at most $2 \times 10^{18}$ cm$^{-3}$. Accordingly, the structure in Example E01 makes it possible to achieve an effect of reducing both the operating voltage and the waveguide loss by causing the average impurity concentration of second P-side guide layer 107 to be at least $5 \times 10^{17}$ cm$^{-3}$ and at most $2 \times 10^{18}$ cm$^{-3}$. In addition, the structure in Example E01 makes it possible to further reduce the waveguide loss to 4.91 cm$^{-1}$ by causing the average impurity concentration of second P-side guide layer 107 to be at most $1 \times 10^{18}$ cm$^{-3}$.

From the above, it is possible to achieve the increase in effective refractive index difference $\Delta$N, the reduction of the operating voltage, and the reduction of the waveguide loss by causing the thickness of second P-side guide layer 107 to be greater than the thickness of first P-side guide layer 105 and the average impurity concentration of second P-side guide layer 107 to be at least $5 \times 10^{17}$ cm$^{-3}$ and at most $2 \times 10^{18}$ cm$^{-3}$, as in Example E01.

The structure according to Example E01 makes it possible to achieve $17.67 \times 10^{-3}$, that is, high effective refractive index difference ΔN greater than or equal to $1 \times 10^{-2}$. Accordingly, it is also possible to solve the problem with the conventional ultraviolet semiconductor laser element, that is, the problem of the gain waveguide structure of the refractive index anti-waveguide type occurring easily due to the reduction of the refractive index of the well layer along with the increase in operating carrier density. When ΔN determined by a waveguide structure is at least $1 \times 10^{-2}$ in a state in which there is no current injection, even if effective refractive index difference ΔN during laser oscillation operation decreases due to the reduction of the refractive index of the well layer along with the increase in operating carrier density of the well layer during the laser oscillation operation, effective refractive index difference ΔN does not become negative and it is possible to maintain a stable refractive index waveguide structure. The reason why such high effective refractive index difference ΔN that is at least $1 \times 10^{-2}$ is obtained is that, as a result of providing electron barrier layer 106 between first P-side guide layer 105 and second P-side guide layer 107 in semiconductor stack 100S according to the present embodiment, it is possible to reduce distance dp between electron barrier layer 106 and active layer 104.

[1-4-2. Example E02]

Example E02 is described below. Nitride semiconductor light-emitting element 100 in Example E02 differs from nitride semiconductor light-emitting element 100 in Example E01 in the thicknesses of N-side guide layer 103, first P-side guide layer 105, and second P-side guide layer 107 (see FIG. 10). Specifically, in Example E02, the thickness (Tng) of N-side guide layer 103 is 140 nm, the thickness (Tpg1) of first P-side guide layer 105 is 72 nm, and the thickness (Tpg2) of second P-side guide layer 107 is 148 nm. As stated above, in Example E02, the total thickness of first P-side guide layer 105 and second P-side guide layer 107 is greater than the thickness of N-side guide layer 103. An effect achieved by this configuration is described using Comparative Example C01 to Comparative Example C03. As shown in FIG. 10, in the nitride semiconductor light-emitting element in Comparative Example C01, the total thickness of the first P-side guide layer and the second P-side guide layer is less than the thickness (Tng) of the N-side guide layer. In the nitride semiconductor light-emitting element in Comparative Example C02, the total thickness of the first P-side guide layer and the second P-side guide layer is equal to the thickness of the N-side guide layer. In a nitride semiconductor light-emitting element in Comparative Example C03, the total thickness of a first P-side guide layer and a second P-side guide layer is greater than the thickness of an N-side guide layer. As is clear from the property calculation results in Comparative Example C01 to Comparative Example C03 shown in FIG. 10, effective refractive index difference ΔN increases with an increase in total thickness of the first P-side guide layer and the second P-side guide layer relative to the thickness of the N-side guide layer. As with Comparative Example C03, in nitride semiconductor light-emitting element 100 in Example E02, since the total thickness of first P-side guide layer 105 and second P-side guide layer 107 is greater than the thickness of N-side guide layer 103, it is possible to increase effective refractive index difference ΔN.

Hereinafter, an example of a P-type impurity (Mg) concentration distribution of nitride semiconductor light-emitting element 100 in Example E02 in the stacking direction is described with reference to FIG. 18. FIG. 18 is a graph schematically showing a band gap energy distribution and a light intensity distribution of semiconductor stack 100S in Example E02, in the stacking direction. FIG. 18 also shows an example of a P-type impurity concentration distribution of semiconductor stack 100S in Example E02, in the stacking direction.

As stated above, the average impurity (Mg) concentration of first P-side guide layer 105 is less than $1.0 \times 10^{18}$ cm$^{-3}$. Accordingly, it is possible to inhibit an increase in waveguide loss of nitride semiconductor light-emitting element 100 and reduce an operating voltage. Additionally, as in the example of the P-type impurity concentration distribution shown in FIG. 18, the impurity concentration of first P-side guide layer 105 may increase with increasing distance from active layer 104. Accordingly, it is possible to decrease an impurity concentration in a region of first P-side guide layer 105 close to active layer 104, that is, a region having a high light intensity, and to increase an impurity concentration in a region of first P-side guide layer 105 far from active layer 104, that is, a region having a low light intensity. As a result, it is possible to achieve both the reduction of the waveguide loss of nitride semiconductor light-emitting element 100 and the reduction of the operating voltage. It should be noted that in this case, the average impurity concentration of first P-side guide layer 105 may be at least $1.0 \times 10^{17}$ cm$^{-3}$ and less than $1.0 \times 10^{18}$ cm$^{-3}$.

Moreover, as stated above, the average impurity concentration of second P-side guide layer 107 is at least $1.0 \times 10^{18}$ cm$^{-3}$. Accordingly, it is possible to reduce the operating voltage of nitride semiconductor light-emitting element 100. In addition, the impurity concentration of second P-side guide layer 107 may increase with increasing distance from active layer 104. Accordingly, it is possible to decrease an impurity concentration in a region of second P-side guide layer 107 close to active layer 104, that is, a region having a high light intensity, and to increase an impurity concentration in a region of second P-side guide layer 107 far from active layer 104, that is, a region having a low light intensity. As a result, it is possible to achieve both the reduction of the waveguide loss of nitride semiconductor light-emitting element 100 and the reduction of the operating voltage. More specifically, an average impurity concentration in the region of second P-side guide layer 107 close to active layer 104, that is, a region from an interface closer to active layer 104 to the center of second P-side guide layer 107 in the stacking direction may be at least $1.0 \times 10^{18}$ cm$^{-3}$ and at most $3.0 \times 10^{18}$ cm$^{-3}$, and an average impurity concentration in a region from the center of second P-side guide layer 107 to an interface farther from active layer 104 may be at least $1.0 \times 10^{19}$ cm$^{-3}$ and at most $1.0 \times 10^{20}$ cm$^{-3}$.

Furthermore, since the activation rate of Mg that is impurities is low in electron barrier layer 106 having a high Al composition ratio, it is necessary to increase an impurity concentration to reduce electrical resistance in electron barrier layer 106. Since Mg diffuses into second P-side guide layer 107 along with doping electron barrier layer 106 with highly concentrated Mg as described above, as shown in FIG. 18, the impurity concentration is high at an interface between second P-side guide layer 107 and electron barrier layer 106, and decreases with decreasing distance from the interface to a position (Px1 or Px2) at which the impurity concentration is minimum.

In view of this, with regard to an impurity concentration in second P-side guide layer 107 and P-type cladding layer 108, as with the example of the P-type impurity concentration distribution shown (the solid line, the dashed line) in FIG. 18, a position (Px1 or Px2) at which the impurity concentration is minimum may be located within a distance of at most 0.2 μm from electron barrier layer 106 toward P-type cladding layer 108 (i.e., upward) in the stacking direction, and the impurity concentration may monotonically increase upward from this position. Since this makes it possible to decrease an impurity concentration in a region that is included in a region obtained by combining second P-side guide layer 107 and P-type cladding layer 108 and is close to active layer 104, it is possible to inhibit an increase in waveguide loss. It should be noted that the position at which the impurity concentration is minimum may be located in second P-side guide layer 107 or P-type cladding layer 108.

In an ultraviolet region in the wavelength range including 375 nm, the influence of light absorption loss between the impurity level and conduction band of Mg used as P-type impurities increases with a decrease in Al composition ratio in an AlGaN layer having an Al composition ratio of at most 6%. For this reason, by decreasing a Mg concentration in the AlGaN layer having the Al composition ratio of at most 6% as much as possible, it is possible to reduce free carrier loss and the influence of the light absorption loss via the impurity level of Mg.

Accordingly, second P-side guide layer 107 may include a region whose Mg concentration decreases with increasing distance from active layer 104. This makes it possible to reduce the free carrier loss along with Mg doping and the influence of the light absorption loss via the impurity level of Mg.

[1-4-3. Example E03]

Example E03 is described below. Nitride semiconductor light-emitting element 100 in Example E03 differs from nitride semiconductor light-emitting element 100 in Example E02 in the Al composition ratio (Xnc) of N-type cladding layer 102 (see FIG. 10). Specifically, the Al composition ratio of N-type cladding layer 102 in Example E03 is 4.5%. As such, in Example E03, the average Al composition ratio of N-type cladding layer 102 is lower than the average Al composition ratio of P-type cladding layer 108.

An effect achieved by this configuration is described using Comparative Example C04, Comparative Example C02, and Comparative Example C05. As shown in FIG. 10, in a nitride semiconductor light-emitting element in Comparative Example C04, the average Al composition ratio of an N-type cladding layer is lower than the average Al composition ratio of a P-type cladding layer. In the nitride semiconductor light-emitting element in Comparative Example C02, the average Al composition ratio of the N-type cladding layer is equal to the average Al composition ratio of the P-type cladding layer. In a nitride semiconductor light-emitting element in Comparative Example C05, the average Al composition ratio of an N-type cladding layer is higher than the average Al composition ratio of a P-type cladding layer.

It is possible to increase the average refractive index of the N-type cladding layer with a decrease in average Al composition ratio of the N-type cladding layer relative to the average Al composition ratio of the P-type cladding layer. Accordingly, it is possible to prevent the peak position of a light intensity distribution of a nitride semiconductor light-emitting element in the stacking direction (i.e., the peak position of a vertical light distribution shown in FIG. 10) from being shifted in a direction from an active layer toward the P-type cladding layer. For this reason, as is clear from the property calculation results in Comparative Example C04, Comparative Example C02, and Comparative Example C05 shown in FIG. 10, it is possible to reduce more waveguide loss with the decrease in average Al composition ratio of the N-type cladding layer relative to the average Al composition ratio of the P-type cladding layer.

As with Comparative Example C04, since the average Al composition ratio of N-type cladding layer 102 is also lower than the average Al composition ratio of P-type cladding layer 108 in nitride semiconductor light-emitting element 100 in Example E03, it is possible to reduce waveguide loss.

[1-4-4. Example E04]

Example E04 is described below. Nitride semiconductor light-emitting element 100 in Example E04 differs from Example E01 in the Al composition ratio of each layer, and is identical to Example E01 in the other configurations. Specifically, as shown in FIG. 11, the Al composition ratios of N-type cladding layer 102, N-side guide layer 103, each barrier layer, first P-side guide layer 105, second P-side guide layer 107, and P-type cladding layer 108 in Example E04 are 10%, 5%, 7%, 4%, 6%, and 10%, respectively.

It should be noted that configurations not shown in FIG. 11 among the configurations of Comparative Examples C11 to C16 are the same as the configurations in Example E04. Nitride semiconductor light-emitting elements in Comparative Example C12 and Comparative Example C16 differ from Example E04 in the Al composition ratio of a first P-side guide layer and the Al composition ratio of a second P-side guide layer, and are identical to Comparative Example E04 in the other configurations. In Comparative Example C12, since the first P-side guide layer and the second P-side guide layer are identical in composition, the average band gap energy of the second P-side guide layer is equal to the average band gap energy of the first P-side guide layer. In addition, in the nitride semiconductor light-emitting element in Comparative Example C16, since the Al composition ratio of the second P-side guide layer is lower than the Al composition ratio of the first P-side guide layer, the average band gap energy of the second P-side guide layer is less than the average band gap energy of the first P-side guide layer.

On the other hand, in nitride semiconductor light-emitting element 100 according to Example E04, since the Al composition ratio of second P-side guide layer 107 is higher than the Al composition ratio of first P-side guide layer 105, the average band gap energy of second P-side guide layer 107 is greater than the average band gap energy of first P-side guide layer 105. A comparison of the property calculation results between Example E04, Comparative Example C12, and Comparative Example C16 shown in FIG. 11 clearly shows that in Example E04, since the proportion of light located in an undoped region in the vicinity of active layer 104 and first P-side guide layer 105 having a low impurity concentration increases in the light distribution in the stacking direction due to the average band gap energy of second P-side guide layer 107 being greater than the average band gap energy of first P-side guide layer 105 (i.e., the refractive index of first P-side guide layer 105 being higher than the refractive index of second P-side guide layer 107), it is possible to increase an optical confinement factor and reduce waveguide loss.

Hereinafter, relations between the Al composition ratios of the respective layers are described with reference to FIG. 12. Nitride semiconductor light-emitting elements in Comparative Example C21 to Comparative Example C23 shown in FIG. 12 differ from Comparative Example C02 in the Al composition ratios (Xng, Xpgl, and Xpg2) of respective guide layers, and are identical to Comparative Example C02 in the other configurations. In Comparative Example C21, Comparative Example C22, and Comparative Example C23, the Al composition ratios of the respective guide layers are 2%, 4%, and 5%. Nitride semiconductor light-emitting elements in Comparative Example C24 to Comparative Example C26 shown in FIG. 12 differ from Comparative Example C12 in the Al composition ratios (Xng, Xpgl, and Xpg2) of respective guide layers, and are identical to Comparative Example C12 in the other configurations. In Comparative Example C24, Comparative Example C25, and Comparative Example C26, the Al composition ratios of the respective guide layers are 4%, 6%, and 7%.

As shown by the property calculation results in Comparative Example C21 to Comparative Example C23 and Comparative Example C02 shown in FIG. 12, when the Al composition ratio of each cladding layer is 6.5% and the Al composition ratio of each guide layer is at least 4%, since the peak position of the vertical light distribution is shifted more considerably in a direction from the active layer toward the P-type cladding layer, the waveguide loss increases. In addition, as shown by the property calculation results in Comparative Example C24 to Comparative Example C26 and Comparative Example C12 shown in FIG. 12, when the Al composition ratio of each cladding layer is 10% and the Al composition ratio of each guide layer is at least 6%, since the peak position of the vertical light distribution is shifted considerably in the direction from the active layer toward the P-type cladding layer, the waveguide loss increases.

Accordingly, in nitride semiconductor light-emitting element 100, the average Al composition ratio of N-side guide layer 103, the average Al composition ratio of first P-side guide layer 105, and the average Al composition ratio of second P-side guide layer 107 may be at most 60% of the average Al composition ratio of P-type cladding layer 108. Since this makes it possible to move the peak position of the light intensity distribution closer to the center of active layer 104 in the stacking direction, it is possible to reduce the waveguide loss. Additionally, the average Al composition ratio of each guide layer may be at most 50% of the average Al composition ratio of P-type cladding layer 108. This makes it possible to further reduce the waveguide loss. However, when the average Al composition ratio of N-side guide layer 103, the average Al composition ratio of first P-side guide layer 105, and the average Al composition ratio of second P-side guide layer 107 are reduced excessively, a difference between the Fermi energy of electrons and a conduction band electric potential in the above three layers during laser oscillation operation decreases, an electron concentration increases, and free carrier loss increases. In order to prevent this from happening, the average Al composition ratio of N-side guide layer 103, the average Al composition ratio of first P-side guide layer 105, and the average Al composition ratio of second P-side guide layer 107 may each be at least 1.5%.

Moreover, although the Al composition ratio of each guide layer is the same value in each comparative example shown in FIG. 12, it is possible to move the peak position of the light intensity distribution much closer to the center of the active layer in the stacking direction by setting the Al composition ratio of each guide layer to satisfy Xpg1 < Xng < Xpg2. Accordingly, it is possible to further reduce the waveguide loss. When the Al composition ratios of the respective guide layers are different from each other as above in nitride semiconductor light-emitting element 100, an average value of the average Al composition ratios of N-side guide layer 103, first P-side guide layer 105, and second P-side guide layer 107 (i.e., an average value of Xng, Xpg1, and Xpg2) may be at most 60% or at most 50% of the average Al composition ratio of P-type cladding layer 108. This makes it possible to further reduce the waveguide loss. However, when the average Al composition ratio of N-side guide layer 103, the average Al composition ratio of first P-side guide layer 105, and the average Al composition ratio of second P-side guide layer 107 are reduced excessively, a difference between the Fermi energy of electrons and a conduction band electric potential in the above three layers during laser oscillation operation decreases, an electron concentration increases, and free carrier loss increases. In order to prevent this from happening, the average Al composition ratio of N-side guide layer 103, the average Al composition ratio of first P-side guide layer 105, and the average Al composition ratio of second P-side guide layer 107 may each be at least 1.5%.

Furthermore, when the average Al composition ratios of N-type cladding layer 102 and P-type cladding layer 108 are different from each other in nitride semiconductor light-emitting element 100, an average value of the average Al composition ratios of N-side guide layer 103, first P-side guide layer 105, and second P-side guide layer 107 (i.e., an average value of Xng, Xpgl, and Xpg2) may be at most 60% or at most 50% of an average value of the average Al composition ratios of N-type cladding layer 102 and P-type cladding layer 108 (i.e., an average value of Xnc and Xpc). However, when the average Al composition ratio of N-side guide layer 103, the average Al composition ratio of first P-side guide layer 105, and the average Al composition ratio of second P-side guide layer 107 are reduced excessively, a difference between the Fermi energy of electrons and a conduction band electric potential in the above three layers during laser oscillation operation decreases, an electron concentration increases, and free carrier loss increases. In order to prevent this from happening, the average Al composition ratio of N-side guide layer 103, the average Al composition ratio of first P-side guide layer 105, and the average Al composition ratio of second P-side guide layer 107 may each be at least 1.5%.

[1-4-5. Example E05]

Example E05 is described below. Nitride semiconductor light-emitting element 100 in Example E05 differs from nitride semiconductor light-emitting element 100 in Example E04 in the thicknesses of N-side guide layer 103, first P-side guide layer 105, and second P-side guide layer 107 (see FIG. 11). Specifically, in Example E05, N-side guide layer 103 has a thickness of 140 nm, first P-side guide layer 105 has a thickness of 72 nm, and second P-side guide layer 107 has a thickness of 148 nm. As stated above, in Example E05, the total thickness of first P-side guide layer 105 and second P-side guide layer 107 is greater than the thickness of N-side guide layer 103. An effect achieved by this configuration is described using Comparative Example C11 to Comparative Example C13. As shown in FIG. 11, in a nitride semiconductor light-emitting element in Comparative Example C11, the total thickness of a first P-side guide layer and a second P-side guide layer is less than the thickness of an N-side guide layer. In the nitride semiconductor light-emitting element in Comparative Example C12, the total thickness of the first P-side guide layer and the second P-side guide layer is equal to the thickness of the N-side guide layer. In a nitride semiconductor light-emitting element in Comparative Example C13, the total thickness of a first P-side guide layer and a second P-side guide layer is greater than the thickness of an N-side guide layer. As is clear from the property calculation results in Comparative Example C11 to Comparative Example C13 shown in FIG. 11, effective refractive index difference ΔN increases with an increase in total thickness of the first P-side guide layer and the second P-side guide layer relative to the thickness of the N-side guide layer. As with Comparative Example C13, in nitride semiconductor light-emitting element 100 in Example E05, since the total thickness of first P-side guide layer 105 and second P-side guide layer 107 is greater than the thickness of N-side guide layer 103, it is possible to increase effective refractive index difference ΔN.

[1-4-6. Example E06]

Example E06 is described below. Nitride semiconductor light-emitting element 100 in Example E06 differs from nitride semiconductor light-emitting element 100 in Example E05 in the Al composition ratio of N-type cladding layer 102 (see FIG. 11). Specifically, the Al composition ratio of N-type cladding layer 102 in Example E06 is 8%. As such, in Example E06, the average Al composition ratio of N-type cladding layer 102 is lower than the average Al composition ratio of P-type cladding layer 108.

An effect achieved by this configuration is described using Comparative Example C14, Comparative Example C12, and Comparative Example C15. As shown in FIG. 11, in a nitride semiconductor light-emitting element in Comparative Example C14, the average Al composition ratio of an N-type cladding layer is lower than the average Al composition ratio of a P-type cladding layer. In the nitride semiconductor light-emitting element in Comparative Example C12, the average Al composition ratio of an N-type cladding layer is equal to the average Al composition ratio of a P-type cladding layer. In a nitride semiconductor light-emitting element in Comparative Example C15, the average Al composition ratio of an N-type cladding layer is higher than the average Al composition ratio of a P-type cladding layer.

It is possible to increase the average refractive index of the N-type cladding layer with a decrease in average Al composition ratio of the N-type cladding layer relative to the average Al composition ratio of the P-type cladding layer. Accordingly, it is possible to prevent the peak position of a light intensity distribution of a nitride semiconductor light-emitting element in the stacking direction (i.e., the peak position of a vertical light distribution) from being shifted in a direction from an active layer toward the P-type cladding layer. For this reason, as is clear from the property calculation results in Comparative Example C14, Comparative Example C12, and Comparative Example C15 shown in FIG. 11, it is possible to reduce waveguide loss with the decrease in average Al composition ratio of the N-type cladding layer relative to the average Al composition ratio of the P-type cladding layer.

As with Comparative Example C14, since the average Al composition ratio of N-type cladding layer 102 is also lower than the average Al composition ratio of P-type cladding layer 108 in nitride semiconductor light-emitting element 100 in Example E06, it is possible to reduce the waveguide loss.

[1-4-7. Example E07]

Example E07 is described below with reference to FIG. 19. FIG. 19 is a graph schematically showing a band gap energy distribution and a light intensity distribution of semiconductor stack 100S in Example E07, in the stacking direction. As shown in FIG. 19, Example E07 differs from Example E01 in including a region in which the Al composition ratios of first P-side guide layer 105 and second P-side guide layer 107 monotonically increase with increasing distance from active layer 104, and is identical to Example E01 in the other configurations. In other words, in Example E07, first P-side guide layer 105 and second P-side guide layer 107 include a band gap gradient region in which band gap energy increases with increasing distance from active layer 104. Here, a configuration in which an Al composition ratio monotonically increases includes a configuration including a region in which an Al composition ratio is constant in the stacking direction. For example, the former configuration also includes a configuration in which an Al composition ratio increases in a stepwise manner. In Example E07, the Al composition ratios of first P-side guide layer 105 and second P-side guide layer 107 are denoted by Xpg1 and Xpg2, respectively. For example, Al composition ratios Xpg1 in the vicinity of an interface of first P-side guide layer 105 closer to active layer 104 and in the vicinity of an interface of first P-side guide layer 105 farther from active layer 104 are 1.5% and 2.5%, respectively. Al composition ratios Xpg2 in the vicinity of an interface of second P-side guide layer 107 closer to active layer 104 and in the vicinity of an interface of second P-side guide layer 107 farther from active layer 104 are 3.5% and 4.5%, respectively.

By causing the Al composition ratios to monotonically increase with increasing distance from active layer 104 in first P-side guide layer 105 and second P-side guide layer 107 as above, it is possible to increase the refractive index of each layer with decreasing distance to active layer 104. Accordingly, since it is possible to increase the refractive index of a region of each of first P-side guide layer 105 and second guide layer 107 close to active layer 104, it is possible to prevent the peak position of the light intensity distribution in the stacking direction from being shifted excessively in the direction from active layer 104 toward P-type cladding layer 108. This makes it possible to reduce waveguide loss.

According to Example E07, it is possible to achieve nitride semiconductor light-emitting element 100 that has an optical confinement factor of 5.52%, effective refractive index difference $\Delta N$ of $20.9 \times 10^{-3}$, waveguide loss of 4.71 cm$^{-1}$, and the peak position of a vertical light distribution that is 15.1 nm.

[1-4-8. Example E08]

Example E08 is described below. Example E08 differs from Example E04 in including a region in which the Al composition ratios of first P-side guide layer 105 and second P-side guide layer 107 monotonically increase with increasing distance from active layer 104, and is identical to Example E04 in the other configurations. In other words, in Example E08, first P-side guide layer 105 and second P-side guide layer 107 include a band gap gradient region in which band gap energy increases with increasing distance from active layer 104. As with Example E07, in Example E08, the Al composition ratios of first P-side guide layer 105 and second P-side guide layer 107 are also denoted by Xpg1 and Xpg2, respectively. For example, Al composition ratios Xpg1 in the vicinity of an interface of first P-side guide layer 105 closer to active layer 104 and in the vicinity of an interface of first P-side guide layer 105 farther from active layer 104 are 3.5% and 4.5%, respectively. Al composition ratios Xpg2 in the vicinity of an interface of second P-side guide layer 107 closer to active layer 104 and in the vicinity of an interface of second P-side guide layer 107 farther from active layer 104 are 5.5% and 6.5%, respectively.

As with Example E07, in Example E08, by causing the Al composition ratios to monotonically increase with increasing distance from active layer 104 in first P-side guide layer 105 and second P-side guide layer 107 as above, it is possible to prevent the peak position of a light intensity distribution in the stacking direction from being shifted excessively in the direction from active layer 104 toward P-type cladding layer 108. This makes it possible to reduce waveguide loss.

It should be noted that although both first P-side guide layer 105 and second P-side guide layer 107 include the band gap gradient region in Example E07 and Example E08, at least one of first P-side guide layer 105 or second P-side guide layer 107 may include the band gap gradient region. Such a configuration also achieves the same effect.

According to Example E08, it is possible to achieve nitride semiconductor light-emitting element 100 that has an optical confinement factor of 6.06%, effective refractive index difference $\Delta N$ of $22.1 \times 10^{-3}$, waveguide loss of 4.37 cm$^{-1}$,

and the peak position of a vertical light distribution that is 13.2 nm.

[1-4-9. Example E09]

Example E09 is described below. Example E09 differs from Example E02 in that first P-side guide layer 105 comprises Al and In, and is identical to Example E02 in the other configurations. In Example E09, first P-side guide layer 105 has a composition of $Al_{0.04}Ga_{0.9516}In_{0.0084}N$. Since first P-side guide layer 105 comprises Al and In as above, it is possible to control the band gap energy of first P-side guide layer 105 and a lattice constant independently.

Hereinafter, a relation between band gap energy in an $Al_xGa_{1-x-y}In_yN$ layer and band gap energy in an $Al_zGa_{1-z}N$ layer ($0 \leq z < 1$) is described with reference to FIG. 20. FIG. 20 is a graph showing a relation between band gap energy in an $Al_xGa_{1-x-y}In_yN$ layer and band gap energy in an $Al_zGa_{1-z}N$ layer. In FIG. 20, the horizontal axis represents In composition ratio y in the $Al_xGa_{1-x-y}In_yN$ layer, and the vertical axis represents Al composition ratio x in the $Al_xGa_{1-x-y}In_yN$ layer. FIG. 20 shows a relation between In composition ratio y and Al composition ratio x to achieve, in the $Al_xGa_{1-x-y}In_yN$ layer, the same band gap energy as the $Al_zGa_{1-z}N$ layer. It should be noted that FIG. 20 shows a relation in each of cases in which Al composition ratio z of the $Al_zGa_{1-z}N$ layer is 0, 0.05, 0.10, 0.15, 0.20, 0.25, 0.30, 0.35, and 0.40. In addition, FIG. 20 shows, by the dashed line, a relation between In composition ratio y and Al composition ratio x to make the lattice constant of the $Al_xGa_{1-x-y}In_yN$ layer and the lattice constant of a GaN layer equal. Accordingly, a region above (or to the left of) the dashed line in the graph of FIG. 20 indicates a composition in which the lattice constant of the $Al_xGa_{1-x-y}In_yN$ layer is smaller than the lattice constant of the GaN layer, and a region below (or to the right of) the dashed line indicates a composition in which the lattice constant of the $Al_xGa_{1-x-y}In_yN$ layer is larger than the lattice constant of the GaN layer. It should be noted that in calculation of lattice constants, 0.311 nm, 0.3182 nm, and 0.354 nm are used as the lattice constants of AlN, GaN, and InN, respectively.

In order to achieve, in the $Al_xGa_{1-x-y}In_yN$ layer, the same band gap energy as the $Al_zGa_{1-z}N$ layer, as shown in FIG. 20, it is necessary that the following Equation (1) be satisfied.

$$x = (-0.1727z + 2.595)y + z \qquad (1)$$

As stated above, it is possible to replace first P-side guide layer 105 including the AlGaN layer in each of the above-described examples with first P-side guide layer 105 including an AlGaInN layer, without changing band gap energy.

Moreover, for example, since tensile strain to substrate 101 is relatively large in semiconductor stack 100S in Example E02, a warp can occur in nitride semiconductor light-emitting element 100. Hereinafter, a warp in nitride semiconductor light-emitting element 100 is described with reference to FIG. 21. FIG. 21 is a schematic side view of the warp of substrate 101 according to the present embodiment and semiconductor stack 100S that occurs when semiconductor stack 100S is stacked on substrate 101.

As shown in FIG. 21, when semiconductor stack 100S is stacked on substrate 101 (i.e., is crystal-grown), a warp occurs in substrate 101 and semiconductor stack 100S due to tensile strain to substrate 101 caused by the AlGaN layers in semiconductor stack 100S. For example, in Example E02, a warp that causes the top face of semiconductor stack 100S to be in a concave shape occurs due to tensile strain to substrate 101 caused by the AlGaN layers. Here, the amount of warp when the top face of semiconductor stack 100S is caused to be in a concave shape (i.e., depth ΔR of the recessed portion indicated by arrows in FIG. 21) is represented by a negative value. In contrast, the amount of warp when the top face of semiconductor stack 100S is caused to be in a convex shape (i.e., the height of the protruding portion) is represented by a positive value.

In Example E09, since it is possible to adjust the lattice constant of first P-side guide layer 105 independently of the band gap energy by adjusting In composition ratio y and Al composition ratio x of first P-side guide layer 105, it is possible to reduce the tensile strain of first P-side guide layer 105 to substrate 101. Accordingly, it is possible to reduce the warp of nitride semiconductor light-emitting element 100. This makes it possible to prevent cracking of a GaN wafer that is a base material of substrate 101 and the occurrence of cracks in the GaN wafer when semiconductor stack 100S is stacked on the GaN wafer and processed.

According to Example E09, it is possible to achieve nitride semiconductor light-emitting element 100 that has an optical confinement factor of 5.62%, effective refractive index difference ΔN of $19.6 \times 10^{-3}$, waveguide loss of 4.90 cm$^{-1}$, and the peak position of a vertical light distribution that is 14.3 nm.

It should be noted that although only first P-side guide layer 105 comprises Al and In in Example E09, N-side guide layer 103, second P-side guide layer 107, and P-type cladding layer 108 may also comprise Al and In. As with Example E01 etc., such a configuration makes it possible to establish relations of the following Equation (2) and Equation (3) between band gap energy Eng of N-side guide layer 103, band gap energy Epg1 of first P-side guide layer 105, band gap energy Epg2 of second P-side guide layer 107, and band gap energy Epc of P-type cladding layer 108.

$$Epg1 < Epg2 < Epc \quad (2)$$

$$Epg1 < Eng < Epg2 \quad (3)$$

The above point is described below using Equation (1). Equation (1) is transformed into the following Equation (4).

$$z = (x - 2.595y) / (1.0 - 0.1727y) \quad (4)$$

Here, since the band gap energy increases with an increase in Al composition ratio z in the $Al_zGa_{1-z}N$ layer, when the following Equation (5) holds, the band gap energy of the $Al_zGa_{1-z}N$ layer becomes greater than the band gap energy of the $Al_xGa_{1-x-y}In_yN$ layer.

$$z > (x - 2.595y) / (1.0 - 0.1727y) \quad (5)$$

From the above, when first P-side guide layer 105 comprises $Al_{Xpg1}Ga_{1-Xpg1-Ypg1}In_{Ypg1}N$ and second P-side guide layer 107 comprises $Al_{Xpg2}Ga_{1-Xpg2-Ypg2}In_{Ypg2}N$, it is possible to cause band gap energy Epg1 of first P-side guide layer 105 to be greater than band gap energy Epg2 of second P-side guide layer 107 by satisfying the following Equation (6).

(Xpg1 - 2.595Ypg1) / (1.0 - 0.1727Ypg1) < (Xpg2 - 2.595Ypg2) / (1.0 - 0.1727Ypg2) (6)     (6)

Moreover, when P-type cladding layer 108 comprises $Al_{Xpc}Ga_{1-Xpc-Ypc}In_{Ypc}N$, Equation (2) holds by satisfying the following Equation (7).

(Xpg1 - 2.595Ypg1) / (1.0 - 0.1727Ypg1) < (Xpg2 - 2.595Ypg2) / (1.0 - 0.1727Ypg2) < (Xpc - 2.595Ypc) / (1.0 - 0.1727Ypc) (7)     (7)

Accordingly, since it is possible to cause the refractive index of first P-side guide layer 105 among first P-side guide layer 105, second P-side guide layer 107, and P-type cladding layer 108 to be highest, it is possible to move the peak position of a vertical light distribution closer to the center of active layer 104 in the stacking direction.

Furthermore, when N-side guide layer 103 comprises $Al_{Xng}Ga_{1-Xng-Yng}In_{Yng}N$, Equation (3) holds by satisfying the following Equation (8).

(Xpg1 - 2.595Ypg1) / (1.0 - 0.1727Ypg1) < (Xng - 2.595Yng) / (1.0 - 0.1727Yng) < (Xpg2 - 2.595Ypg2) / (1.0 - 0.1727Ypg2) (8)     (9)

Accordingly, it is possible to cause the refractive index of first P-side guide layer 105 to be higher than the refractive index of each of N-side guide layer 103 and second P-side guide layer 107. For this reason, it is possible to move the peak position of the vertical light distribution much closer to the center of active layer 104 in the stacking direction.

[1-4-10. Example E10]

Example E10 is described below. Example E10 differs from Example E05 in that first P-side guide layer 105 comprises Al and In, and is identical to Example E05 in the other configurations. In Example E10, first P-side guide layer 105 has a composition of $Al_{0.04}Ga_{0.9516}In_{0.0084}N$. Since first P-side guide layer 105 comprises Al and In as above, Example E10 also achieves the same effect as Example E09.

According to Example E10, it is possible to achieve nitride semiconductor light-emitting element 100 that has an optical confinement factor of 6.12%, effective refractive index difference $\Delta N$ of $22.3 \times 10^{-3}$, waveguide loss of 4.02 cm$^{-1}$, and the peak position of a vertical light distribution that is 14.0 nm.

[1-4-11. Example E11]

Example E11 is described below. Example E11 differs from Example E02 in that N-type cladding layer 102 comprises Al and In, and is identical to Example E02 in the other configurations. In Example E11, N-type cladding layer 102 has a composition of $Al_{0.065}Ga_{0.925}In_{0.01}N$. An effect achieved by N-type cladding layer 102 comprising Al and In as above is described with reference to FIG. 22 to FIG. 24. FIG. 22 is a graph showing a relation between a position and band gap energy in semiconductor stack 100S in Example E11, in the stacking direction. FIG. 23 is a graph showing a relation between a position and stress in semiconductor stack 100S in Example E11, in the stacking direction. The stress shown in FIG. 23 is stress on substrate 101. A positive stress value means that stress is compressible, and a negative stress value means that stress is tensile. It should be noted that, in FIG. 23, stress when N-type cladding layer 102 comprises $Al_{0.063}Ga_{0.933}N$ is also shown by the dashed line as with Example E02. FIG. 24 is a graph showing a relation between a position and integrated stress in semiconductor stack 100S in Example E11, in the stacking direction. Here, integrated stress means a value calculated by integrating stress at respective positions in the stacking direction of semiconductor stack 100S from an interface between N-type cladding layer 102 and substrate 101 in semiconductor stack 100S upward in the stacking direction. In other words, integrated stress means a value calculated by integrating the stress shown in FIG. 23 from the zero position to the respective positions in the stacking direction. It should be noted that, in FIG. 24, integrated stress when N-type cladding layer 102 comprises $Al_{0.065}Ga_{0.935}N$ is also shown by the dashed line as with Example E02.

As shown in FIG. 22, Example E11 makes it possible to reduce the band gap energy of N-type cladding layer 102, compared to Example E02. In other words, Example E11 makes it possible to increase the refractive index of N-type cladding layer 102, compared to Example E02. Accordingly, it is possible to prevent the peak position of a light intensity distribution in the stacking direction from being shifted excessively in the direction from active layer 104 toward P-type cladding layer 108.

Moreover, as shown in FIG. 23 and FIG. 24, Example E11 makes it possible to reduce the tensile stress (strain) in N-type cladding layer 102, compared to Example E02. For example, when semiconductor stack 100S in Example E02 is stacked on a GaN substrate having a size of 5 cm × 5 cm and a thickness of 85 μm, integrated stress is -725.8 Pa·m and the amount of warp of the wafer (see FIG. 21) is 553.6 μm. In contrast, when semiconductor stack 100S in Example E11 is stacked on a GaN substrate having a size of 5 cm × 5 cm and a thickness of 85 μm, integrated stress is -436.4 Pa·m and the amount of warp of the wafer is 335.0 μm. Since Example E11 makes it possible to reduce the warp of the wafer as above, it is possible to prevent cracking of the wafer and the occurrence of cracks in the wafer.

According to Example E11, it is possible to achieve nitride semiconductor light-emitting element 100 that has an optical confinement factor of 4.95%, effective refractive index difference $\Delta N$ of $9.29 \times 10^{-3}$, waveguide loss of 4.23 cm$^{-1}$, and the peak position of a vertical light distribution that is 8.2 nm.

[1-4-12. Example E12]

Example E12 is described below. Example E12 differs from Example E05 in that N-type cladding layer 102 comprises Al and In, and is identical to Example E05 in the other configurations. In Example E12, N-type cladding layer 102 has a composition of $Al_{0.10}Ga_{0.89}In_{0.01}N$. An effect achieved by N-type cladding layer 102 comprising Al and In as above is described with reference to FIG. 25 to FIG. 27. FIG. 25 is a graph showing a relation between a position and band gap energy in semiconductor stack 100S in Example E12, in the stacking direction. FIG. 26 is a graph showing a relation between a position and stress in semiconductor stack 100S in Example E12, in the stacking direction. It should be noted that, in FIG. 26, stress when N-type cladding layer 102 comprises $Al_{0.10}Ga_{0.90}N$ is also shown by the dashed line as with Example E05. FIG. 27 is a graph showing a relation between a position and integrated stress in semiconductor stack 100S in Example E12, in the stacking direction. It should be noted that, in FIG. 27, integrated stress when N-type cladding layer 102 comprises $Al_{0.10}Ga_{0.90}N$ is also shown by the dashed line as with Example E05.

When semiconductor stack 100S in Example E12 is stacked on a GaN substrate having a size of 5 cm × 5 cm and a thickness of 85 μm, integrated stress is -835.5 Pa·m and the amount of warp of the wafer (see FIG. 21) is 639.4 μm. In contrast, when semiconductor stack 100S in which N-type cladding layer 102 comprises $Al_{0.10}Ga_{0.90}N$ as with Example E05 is stacked on a GaN substrate having a size of 5 cm × 5 cm and a thickness of 85 μm, integrated stress is -1126.4 Pa·m and the amount of warp of the wafer is 858.9 μm. As shown in FIG. 25 to FIG. 27, since N-type cladding layer 102 comprises Al and In, Example E12 also achieves the same effect as Example E11.

According to Example E12, it is possible to achieve nitride semiconductor light-emitting element 100 that has an optical confinement factor of 5.87%, effective refractive index difference $\Delta N$ of $10.9 \times 10^{-3}$, waveguide loss of 3.5 cm$^{-1}$, and the peak position of a vertical light distribution that is 11.0 nm.

[1-4-13. Example E13]

Example E13 is described below. Example E13 differs from Example E02 in that well layer 104b comprises Al and In, and is identical to Example E02 in the other configurations. In Example E13, well layer 104b has a composition of $Al_{0.071}Ga_{0.889}In_{0.04}N$.

In order to emit at least 375-nm light and at most 380-nm light, it is necessary to use, in nitride semiconductor light-emitting element 100, well layer 104b that has a band gap energy that is greater than or equal to the band gap energy of $In_{0.01}Ga_{0.99}N$ and less than or equal to the band gap energy of GaN. Hereinafter, the composition of well layer 104b is described with reference to FIG. 28. FIG. 28 is a graph for illustrating a composition required for well layer 104b in Example E13. In FIG. 28, the horizontal axis represents In composition ratio y, and the vertical axis represents Al composition ratio x.

When the composition of well layer 104b is set to $Al_xGa_{1-x-y}In_yN$, the following Equation (9) may be satisfied to cause the band gap energy of well layer 104b to be greater than or equal to the band gap energy of $In_{0.01}Ga_{0.99}N$ and less than or equal to the band gap energy of GaN.

$$2.34y \geq x \geq 2.34y - 0.234 \qquad (9)$$

In other words, when Al composition ratio x and In composition ratio y of well layer 104b are values corresponding to a region between the solid line and the dashed line shown in FIG. 28, it is possible to emit at least 375-nm light and at most 380-nm light.

Hereinafter, lattice misfit with GaN in well layer 104b is described with reference to FIG. 29. FIG. 29 is a graph showing the In composition ratio of well layer 104b and lattice misfit with GaN.

For example, since $In_{0.01}Ga_{0.99}N$ has a compressible lattice misfit with GaN of 0.11%, a compressible lattice misfit that occurs in well layer 104b when the composition of well layer 104b is set to $In_{0.01}Ga_{0.99}N$ is 0.11% at most. In comparison, the following describes a case in which the composition of well layer 104b is set to $Al_xGa_{1-x-y}In_yN$ that has Al composition ratio x and In composition ratio y that satisfy Equation (9). In this case, for example, when In composition ratio y is 0.04, as shown in FIG. 29, a compressible lattice misfit that occurs in well layer 104b is at least 0.23% and at most 0.28%. Since well layer 104b comprises Al and In as above, it is possible to increase the compressible lattice misfit that occurs in well layer 104b. Accordingly, it is possible to reduce tensile strain in active layer 104 and a region surrounding active layer 104. Since, as shown in FIG. 29, it is possible to increase the compressible lattice misfit of well layer 104b to at least 0.34% and at most 0.38% when In composition ratio y in well layer 104b is, for example, 0.06, it is possible to further reduce the tensile strain in active layer 104 and the region surrounding active layer 104.

Moreover, a difference in ground level energy between heavy holes and light holes formed in well layer 104b increases by increasing the compressible strain of well layer 104b. As a result, since it is possible to increase the number of heavy holes at a ground level when nitride semiconductor light-emitting element 100 is caused to operate by being supplied with a current, it is possible to decrease an oscillation threshold current value. Accordingly, since it is possible to reduce an operating carrier density, it is possible to inhibit a change in refractive index of a current injection region in well layer 104b and a decrease in refractive index due to a plasma effect. From the above, since it is possible to inhibit a decrease in effective refractive index difference ΔN, it is possible to stabilize the horizontal lateral mode of laser light.

According to Example E13, it is possible to achieve nitride semiconductor light-emitting element 100 that has an optical confinement factor of 5.69%, effective refractive index difference ΔN of $18.79 \times 10^{-3}$, waveguide loss of 4.96 cm$^{-1}$, and the peak position of a vertical light distribution that is 12.84 nm.

[1-4-14. Example E14]

Example E14 is described below. Example E14 differs from Example E01 in the configuration of N-side guide layer 103, and is identical to Example E01 in the other configurations. Hereinafter, the configuration of semiconductor stack 100S in Example E14 is described below with reference to FIG. 30. FIG. 30 is a graph schematically showing a band gap energy distribution of semiconductor stack 100S in Example E14, in the stacking direction.

As shown in FIG. 30, N-side guide layer 103 in Example E14 includes first N-side guide layer 103a and second N-side guide layer 103b that is disposed above first N-side guide layer 103a. The band gap energy of first N-side guide layer 103a is greater than the band gap energy of second N-side guide layer 103b. Additionally, Al composition ratio Xng1 of first N-side guide layer 103a is higher than Al composition ratio Xng of second N-side guide layer 103b. Specifically, first N-side guide layer 103a is an undoped $Al_{0.04}Ga_{0.96}N$ layer that has a thickness of 90 nm. In other words, Al composition ratio Xng1 of first N-side guide layer 103a is 4.0%. In contrast, second N-side guide layer 103b is an undoped $Al_{0.02}Ga_{0.98}N$ layer that has a thickness of 90 nm. In other words, Al composition ratio Xng2 of second N-side guide layer 103b is 2.0%.

In Example E14, average Al composition ratio Xng of N-side guide layer 103 is 3.0% and satisfies Xpg1 < Xng < Xpg2.

The average Al composition ratio of N-side guide layer 103 refers to an average Al composition ratio in consideration of an Al composition ratio distribution in two layers of first N-side guide layer 103a and second N-side guide layer 103b. More specifically speaking, the average Al composition ratio of N-side guide layer 103 refers to an Al composition ratio value obtained by (i) integrating the magnitude of an Al composition ratio at a position in the two layers of first N-side guide layer 103a and second N-side guide layer 103b from the position of an interface of first N-side guide layer 103a on a substrate 101 side to the position of an interface of second N-side guide layer 103b on an active layer 104 side in the stacking direction and (i) dividing the integrated magnitude of the Al composition ratios by the total thickness of first N-side guide layer 103a and second N-side guide layer 103b.

By the average Al composition ratio of N-side guide layer 103 satisfying the above inequality, the average refractive index of first P-side guide layer 105 becomes higher than the average refractive index of N-side guide layer 103, and the average refractive index of N-side guide layer 103 becomes higher than the average refractive index of second P-side guide layer 107.

Here, the average refractive index of N-side guide layer 103 means an average refractive index in consideration of a refractive index distribution in the two layers of first N-side guide layer 103a and second N-side guide layer 103b. More specifically speaking, the average refractive index of N-side guide layer 103 refers to a refractive index value obtained by (i) integrating the magnitude of a refractive index at a position in the two layers of first N-side guide layer 103a and second N-side guide layer 103b from the position of the interface of first N-side guide layer 103a on the substrate 101 side to the position of the interface of second N-side guide layer 103b on the active layer 104 side in the stacking direction and (i) dividing the integrated magnitude of the refractive indexes by the total thickness of first N-side guide layer 103a and second N-side guide layer 103b.

An effect achieved by Example E14 is described in comparison with a semiconductor stack in Comparative Example C30. Semiconductor stack 100S in Comparative Example C30 is an example of semiconductor stack 100S according to Embodiment 1, differs from Example E14 in that the band gap energy of first N-side guide layer 103a is less than the band gap energy of second N-side guide layer 103b, and is identical to Example E14 in the other configurations. In Comparative Example C30, first N-side guide layer 103a is an undoped $Al_{0.02}Ga_{0.98}N$ layer having a thickness of 90 nm, and second N-side guide layer 103b is an undoped $Al_{0.04}Ga_{0.96}N$ layer having a thickness of 90 nm. As stated above, in Comparative Example C30, the average Al composition ratio of N-side guide layer 103 is the same as in Example E01 and Example E14, the Al composition ratio of first N-side guide layer 103a that is a region of N-side guide layer 103 far from active layer 104 is 2%, and the Al composition ratio of second N-side guide layer 103b that is a region of N-side guide layer 103 close to active layer 104 is 4%.

A nitride semiconductor light-emitting element including the semiconductor stack in Comparative Example C30 has an optical confinement factor of 5.1%, effective refractive index difference $\Delta N$ of $16.8 \times 10^{-3}$, waveguide loss of 6.1 $cm^{-1}$, and the peak position of a vertical light distribution that is 11.6 nm. As stated above, each property in the nitride semiconductor light-emitting element including the semiconductor stack in Comparative Example C30 is not as good as Example E01.

In contrast, when the Al composition ratio (Xng2) of the region of N-side guide layer 103 close to active layer 104 is decreased as in Example E14, the refractive index of the region of N-side guide layer 103 close to active layer 104 becomes higher than the refractive index of the region of N-side guide layer 103 far from active layer 104. For this reason, a proportion of light in undoped first N-side guide layer 103a, second N-side guide layer 103b, and first P-side guide layer 105 in the vicinity of active layer 104 increases. Accordingly, in nitride semiconductor light-emitting element 100 including semiconductor stack 100S in Example E14, waveguide loss is further reduced and a light confinement factor to active layer 104 further increases, compared to nitride semiconductor light-emitting element 100 including semiconductor stack 100S in Example E01.

Specifically, according to Example E14, it is possible to achieve nitride semiconductor light-emitting element 100 that has an optical confinement factor of 6.2%, effective refractive index difference $\Delta N$ of $17.4 \times 10^{-3}$, waveguide loss of 3.6 $cm^{-1}$, and the peak position of a vertical light distribution that is 5.6 nm.

As stated above, according to Example E14, it is possible to achieve effective refractive index difference $\Delta N$ of at least $10 \times 10^{-3}$ while causing the peak position of the vertical light distribution to be in a well layer 104b region of active layer 104, and to aim at the reduction of the waveguide loss and the increase in optical confinement factor.

[1-4-15. Example E15]

Example E15 is described below. Example E15 differs from Example E01 in the configuration of N-side guide layer 103, and is identical to Example E01 in the other configurations. Hereinafter, the configuration of semiconductor stack 100S in Example E15 is described below with reference to FIG. 31. FIG. 31 is a graph schematically showing a band gap energy distribution of semiconductor stack 100S in Example E15, in the stacking direction.

As shown in FIG. 31, N-side guide layer 103 in Example E15 differs from N-side guide layer 103 in Example E01 in including a region in which an Al composition ratio monotonically increases with increasing distance from active layer 104. In other words, in Example E15, N-side guide layer 103 includes a band gap gradient region in which band gap energy increases with increasing distance from active layer 104. Al composition ratios Xng in the vicinity of an interface of N-side guide layer 103 closer to active layer 104 and in the vicinity of an interface of N-side guide layer 103 farther from active layer 104 are 2.0% and 4.0%, respectively.

In Example E15, average Al composition ratio Xng of N-side guide layer 103 is 3.0% and satisfies Xpg1 < Xng < Xpg2.

By the average Al composition ratio of N-side guide layer 103 satisfying the above inequality, the average refractive index of first P-side guide layer 105 becomes higher than the average refractive index of N-side guide layer 103, and the average refractive index of N-side guide layer 103 becomes higher than the average refractive index of second P-side guide layer 107.

When the Al composition ratio of a region of N-side guide layer 103 close to active layer 104 is decreased, the refractive index of the region of N-side guide layer 103 close to active layer 104 becomes higher than the refractive index of a region of N-side guide layer 103 far from active layer 104. For this reason, a proportion of light in undoped N-side guide layer 103 and first P-side guide layer 105 in the vicinity of active layer 104 increases. Accordingly, in nitride semiconductor light-emitting element 100 including semiconductor stack 100S in Example E15, waveguide loss is further reduced and a light confinement factor to active layer 104 further increases, compared to nitride semiconductor light-emitting element 100 including semiconductor stack 100S in Example E01.

Specifically, according to Example E15, it is possible to achieve nitride semiconductor light-emitting element 100 that has an optical confinement factor of 5.9%, effective refractive index difference $\Delta N$ of $17.4 \times 10^{-3}$, waveguide loss of 4.1 cm$^{-1}$, and the peak position of a vertical light distribution that is 6.5 nm.

As stated above, according to Example E15, it is possible to achieve effective refractive index difference $\Delta N$ of at least $10 \times 10^{-3}$ while causing the peak position of the vertical light distribution to be in a well layer 104b region of active layer 104, and to aim at the reduction of the waveguide loss and the increase in optical confinement factor.

[Embodiment 2]

A nitride semiconductor light-emitting element according to Embodiment 2 is described below. The nitride semiconductor light-emitting element according to the present embodiment differs from nitride semiconductor light-emitting element 100 according to Embodiment 1 in including a buffer layer. Hereinafter, the nitride semiconductor light-emitting element according to present embodiment is described with reference to FIG. 32, focusing mainly on differences from nitride semiconductor light-emitting element 100 according to Embodiment 1. FIG. 32 is a schematic cross-sectional view of the overall configuration of nitride semiconductor light-emitting element 200 according to the present embodiment.

As shown in FIG. 32, nitride semiconductor light-emitting element 200 according to the present embodiment includes substrate 101, semiconductor stack 200S, current blocking layer 110, P-side electrode 111, and N-side electrode 112. Semiconductor stack 200S according to the present embodiment differs from semiconductor stack 100S according to Embodiment 1 in including buffer layer 221, and is identical to semiconductor stack 100S according to Embodiment 1 in the other points.

Buffer layer 221 is an example of a first buffer layer that is disposed between substrate 101 and N-type cladding layer 102 and comprises InGaN. In the present embodiment, buffer layer 221 is an N-type In$_{0.05}$Ga$_{0.95}$N layer that is doped with Si at a concentration of $5 \times 10^{17}$ cm$^{-3}$ and has a thickness of 150 nm.

Since nitride semiconductor light-emitting element 200 according to the present embodiment includes buffer layer 221, nitride semiconductor light-emitting element 200 is capable of applying compressible strain to semiconductor stack 200S. Since this makes it possible to reduce tensile strain of semiconductor stack 200S, it is possible to prevent cracking of a GaN wafer and the occurrence of cracks in the GaN wafer when semiconductor stack 200S is stacked on the GaN wafer and processed. For example, when semiconductor stack 200S is stacked on a GaN substrate having a size of 5 cm $\times$ 5 cm and a thickness of 85 $\mu$m, integrated stress is -173.4 Pa·m and the amount of warp of the wafer is 138.1 $\mu$m.

Moreover, in the case where a GaN substrate is used as substrate 101, when light reaches substrate 101, the light diffuses throughout substrate 101 because the refractive index of substrate 101 is higher than the effective refractive index of semiconductor stack 200S relative to a waveguide mode. In this case, since an optical confinement factor to active layer 104 in the waveguide mode decreases and waveguide loss increases, an oscillation threshold current value increases. As a result, an operating carrier density in well layer 104b increases, effective refractive index difference $\Delta N$ decreases due to a decrease in refractive index of a current injection region in well layer 104b, and a waveguide structure for light propagating through a waveguide including ridge 108R becomes a waveguide structure of a refractive index anti-waveguide type. Accordingly, a horizontal lateral mode stabilizes, and kinks are likely to occur in current-light output characteristics.

In contrast, since nitride semiconductor light-emitting element 200 according to the present embodiment includes buffer layer 221 that comprises InGaN having band gap energy less than energy equivalent to ultraviolet light, buffer layer 221 absorbs light, which makes it possible to prevent the light from reaching substrate 101.

According to the present embodiment, it is possible to achieve nitride semiconductor light-emitting element 200 that has an optical confinement factor of 5.69%, effective refractive index difference $\Delta N$ of $18.79 \times 10^{-3}$, waveguide loss of 4.96 cm$^{-1}$, and the peak position of a vertical light distribution that is 12.84 nm.

[Embodiment 3]

A nitride semiconductor light-emitting element according to Embodiment 3 is described below. The nitride semiconductor light-emitting element according to the present embodiment differs from nitride semiconductor light-emitting element 200 according to Embodiment 2 in including two buffer layers. Hereinafter, the nitride semiconductor light-emitting element according to present embodiment is described with reference to FIG. 33, focusing mainly on differences from nitride semiconductor light-emitting element 200 according to Embodiment 2. FIG. 33 is a schematic cross-sectional view of the overall configuration of nitride semiconductor light-emitting element 300 according to the present embodiment.

As shown in FIG. 33, nitride semiconductor light-emitting element 300 according to the present embodiment includes substrate 101, semiconductor stack 300S, current blocking layer 110, P-side electrode 111, and N-side electrode 112. Semiconductor stack 300S according to the present embodiment differs from semiconductor stack 200S according to Embodiment 2 in including buffer layer 321, and is identical to semiconductor stack 200S according to Embodiment 2 in the other points.

Buffer layer 321 is an example of a second buffer layer that is disposed between substrate 101 and N-type cladding layer 102 and comprises AlGaN. In the present embodiment, buffer layer 321 is disposed between substrate 101 and buffer layer 221. Buffer layer 321 is an N-type $Al_{0.007}Ga_{0.993}N$ layer that is doped with Si at a concentration of $5 \times 10^{17}$ $cm^{-3}$ and has a thickness of 1000 nm.

Nitride semiconductor light-emitting element 300 according to the present embodiment achieves the same effect as nitride semiconductor light-emitting element 200 according to Embodiment 2. For example, when semiconductor stack 300S is stacked on a GaN substrate having a size of 5 cm $\times$ 5 cm and a thickness of 85 $\mu$m, integrated stress is -227.5 Pa·m and the amount of warp of the wafer is 173.8 $\mu$m.

According to the present embodiment, it is possible to achieve nitride semiconductor light-emitting element 300 that has an optical confinement factor of 5.69%, effective refractive index difference $\Delta N$ of $18.79 \times 10^{-3}$, waveguide loss of 4.96 $cm^{-1}$, and the peak position of a vertical light distribution that is 12.84 nm.

[Variations etc.]

Although the nitride semiconductor light-emitting element according to the present disclosure has been described above based on each of the embodiments, the present disclosure is not limited to each of the aforementioned embodiments.

For example, although each of the aforementioned embodiments shows an example in which the nitride semiconductor light-emitting element is a semiconductor laser element, the nitride semiconductor light-emitting element is not limited to a semiconductor laser element. For example, the nitride semiconductor light-emitting element may be a superluminescent diode. In this case, the reflectance of an end face of the semiconductor stack included in the nitride semiconductor light-emitting element relative to emission light from the semiconductor stack may be at most 0.1%. It is possible to achieve such a reflectance by, for example, forming an antireflection film including a dielectric multilayer film etc. on the end face. Alternatively, by forming a tilted stripe structure in which a ridge that serves as a waveguide intersects a front end face at at least a 5-degree tilt from a normal direction of the front end face, it is possible to cause the percentage of components that become guided light by guided light reflected from the front end face being combined again with the waveguide to be a small value of at most 0.1%.

Moreover, although P-type cladding layer 108 is a layer having an even Al composition ratio, the configuration of P-type cladding layer 108 is not limited to this example. For example, P-type cladding layer 108 may have a superlattice structure in which each of a plurality of AlGaN layers and each of a plurality of GaN layers are alternately stacked.

Furthermore, forms obtained by various modifications to each of the aforementioned embodiments that can be conceived by a person skilled in the art as well as forms realized by arbitrarily combining the constituent elements and functions in each of the aforementioned embodiments as long as they are within the spirit of the present disclosure are included in the present disclosure.

For example, the respective buffer layers according to Embodiment 2 and Embodiment 3 may be applied to each of the examples of nitride semiconductor light-emitting element 100 according to Embodiment 1.

[Industrial Applicability]

The nitride semiconductor light-emitting element of the present disclosure is applicable to, for example, an exposure device and a light source for processing machine, as a high-power and highly efficient light source.

[Reference Signs List]

100, 200, 300 nitride semiconductor light-emitting element
100F, 100R end face
100S, 200S, 300S semiconductor stack
101 substrate
102 N-type cladding layer
103 N-side guide layer
103a first N-side guide layer
103b second N-side guide layer
104 active layer
104a, 104c barrier layer
104b well layer
105 first P-side guide layer
106, 916, 926 electron barrier layer
107 second P-side guide layer
108 P-type cladding layer
108R ridge
108T trench
109 contact layer
110 current blocking layer
111 P-side electrode
112 N-side electrode
221, 321 buffer layer
915, 925 P-side guide layer

**Claims**

1. A nitride semiconductor light-emitting element comprising:

   an N-type cladding layer;
   an N-side guide layer disposed above the N-type cladding layer;
   an active layer disposed above the N-side guide layer;
   a first P-side guide layer disposed above the active layer;
   an electron barrier layer disposed above the first P-side guide layer;
   a second P-side guide layer disposed above the electron barrier layer;
   a P-type cladding layer disposed above the second P-side guide layer,
   wherein an average band gap energy of the second P-side guide layer is greater than an average band gap energy of the first P-side guide layer, and
   an average band gap energy of the P-type cladding layer is less than an average band gap energy of the electron barrier layer.

2. The nitride semiconductor light-emitting element according to claim 1,
   wherein the active layer includes two barrier layers and a well layer that is disposed between the two barrier layers.

3. The nitride semiconductor light-emitting element according to claim 2,
   wherein a band gap energy of each of the two barrier layers is greater than the average band gap energy of the first P-side guide layer, is greater than an average band gap energy of the N-side guide layer, and is less than a band gap energy of the electron barrier layer.

4. The nitride semiconductor light-emitting element according to claim 2 or claim 3,
   wherein the well layer comprises Al and In.

5. The nitride semiconductor light-emitting element according to any one of claim 2 to claim 4,
   wherein a thickness of the first P-side guide layer is greater than a thickness of each of the two barrier layers.

6. The nitride semiconductor light-emitting element according to any one of claim 1 to claim 5,
wherein an average band gap energy of the N-side guide layer is greater than the average band gap energy of the first P-side guide layer.

7. The nitride semiconductor light-emitting element according to claim 6,
wherein at least one of the first P-side guide layer or the second P-side guide layer includes a band gap gradient region in which a band gap energy increases with increasing distance from the active layer.

8. The nitride semiconductor light-emitting element according to claim 6 or claim 7,
wherein the average band gap energy of the N-side guide layer is less than the average band gap energy of the second P-side guide layer.

9. The nitride semiconductor light-emitting element according to any one of claim 6 to claim 8,
wherein a total thickness of the first P-side guide layer and the second P-side guide layer is greater than a thickness of the N-side guide layer.

10. The nitride semiconductor light-emitting element according to any one of claim 1 to claim 9,
wherein an average impurity concentration of the first P-side guide layer is less than $1 \times 10^{18}$ cm$^{-3}$.

11. The nitride semiconductor light-emitting element according to any one of claim 1 to claim 10,
wherein an average impurity concentration of the second P-side guide layer is at least $1 \times 10^{18}$ cm$^{-3}$.

12. The nitride semiconductor light-emitting element according to any one of claim 1 to claim 11,

    wherein the N-type cladding layer and the P-type cladding layer comprise Al, and
    an average Al composition ratio of the N-type cladding layer is lower than or equal to an average Al composition ratio of the P-type cladding layer.

13. The nitride semiconductor light-emitting element according to claim 12,

    wherein the N-side guide layer, the first P-side guide layer, and the second P-side guide layer comprise Al, and
    an average Al composition ratio of the N-side guide layer, an average Al composition ratio of the first P-side guide layer, and an average Al composition ratio of the second p-side guide layer are at most 60 percent of the average Al composition ratio of the P-type cladding layer.

14. The nitride semiconductor light-emitting element according to any one of claim 1 to claim 13,
wherein the N-type cladding layer comprises Al and In.

15. The nitride semiconductor light-emitting element according to any one of claim 1 to claim 14,
wherein the first P-side guide layer comprises Al and In.

16. The nitride semiconductor light-emitting element according to any one of claim 1 to claim 15,
wherein a thickness of the second P-side guide layer is greater than a thickness of the first P-side guide layer.

17. The nitride semiconductor light-emitting element according to any one of claim 1 to claim 16, further comprising:

    a substrate that is disposed below the N-type cladding layer and comprises GaN; and
    a buffer layer that is disposed between the substrate and the N-type cladding layer and comprises InGaN.

18. The nitride semiconductor light-emitting element according to any one of claim 1 to claim 17,
wherein the active layer emits ultraviolet light.

FIG. 1

# FIG. 2A

# FIG. 2B

## FIG. 3

## FIG. 4

# FIG. 5

# FIG. 6

## FIG. 7

## FIG. 8

FIG. 9

## FIG. 10

| Example/Comparative Example number | | C01 | C02 | C03 | C04 | C02 | C05 | E01 | C02 | C06 | C03 | E02 | E03 |
|---|---|---|---|---|---|---|---|---|---|---|---|---|---|
| Al composition ratio | N-type cladding layer Xnc [%] | 6.5 | 6.5 | 6.5 | 4.5 | 6.5 | 8.5 | 6.5 | 6.5 | 6.5 | 6.5 | 6.5 | 4.5 |
| | N-type guide layer Xng [%] | 3 | 3 | 3 | 3 | 3 | 3 | 3 | 3 | 3 | 3 | 3 | 3 |
| | Barrier layer Xb [%] | 4 | 4 | 4 | 4 | 4 | 4 | 4 | 4 | 4 | 4 | 4 | 4 |
| | First P-side guide layer Xpg1 [%] | 3 | 3 | 3 | 3 | 3 | 3 | 2 | 3 | 4 | 3 | 2 | 2 |
| | Second P-side guide layer Xpg2 [%] | 3 | 3 | 3 | 3 | 3 | 3 | 4 | 3 | 2 | 3 | 4 | 4 |
| | P-type cladding layer Xpc [%] | 6.5 | 6.5 | 6.5 | 6.5 | 6.5 | 6.5 | 6.5 | 6.5 | 6.5 | 6.5 | 6.5 | 6.5 |
| Thickness | N-side guide layer Tng [nm] | 220 | 180 | 140 | 180 | 180 | 180 | 180 | 180 | 180 | 140 | 140 | 140 |
| | First P-side guide layer Tpg1 [nm] | 40 | 56 | 72 | 56 | 56 | 56 | 56 | 56 | 56 | 72 | 72 | 72 |
| | Second P-side guide layer Tpg2 [nm] | 100 | 124 | 148 | 124 | 124 | 124 | 124 | 124 | 124 | 148 | 148 | 148 |
| Property calculation results | Optical confinement factor [%] | 4.86 | 4.87 | 4.45 | 4.71 | 4.87 | 4.87 | 5.65 | 4.87 | 4.03 | 4.45 | 5.69 | 5.46 |
| | $\Delta N$ [$10^{-3}$] | 18.78 | 20.84 | 23.15 | 14.36 | 20.84 | 23.96 | 17.67 | 20.84 | 25.22 | 23.15 | 18.79 | 12.72 |
| | Waveguide loss [$cm^{-1}$] | 6.69 | 6.19 | 6.97 | 4.80 | 6.19 | 6.96 | 4.91 | 6.19 | 6.94 | 6.97 | 4.96 | 3.60 |
| | Vertical light distribution peak position [nm] | 6.56 | 10.37 | 13.52 | 7.74 | 10.37 | 11.62 | 9.33 | 10.37 | 12.40 | 13.52 | 12.84 | 9.66 |

EP 4 481 964 A1

## FIG. 11

| Example/Comparative Example number | | C11 | C12 | C13 | C14 | C12 | C15 | E04 | C12 | C16 | C13 | E05 | E06 |
|---|---|---|---|---|---|---|---|---|---|---|---|---|---|
| Al composition ratio | N-type cladding layer Xnc [%] | 10 | 10 | 10 | 8 | 10 | 12 | 10 | 10 | 10 | 10 | 10 | 8 |
| | N-type guide layer Xng [%] | 5 | 5 | 5 | 5 | 5 | 5 | 5 | 5 | 5 | 5 | 5 | 5 |
| | Barrier layer Xb [%] | 7 | 7 | 7 | 7 | 7 | 7 | 7 | 7 | 7 | 7 | 7 | 7 |
| | First P-side guide layer Xpg1 [%] | 5 | 5 | 5 | 5 | 5 | 5 | 4 | 5 | 6 | 5 | 4 | 4 |
| | Second P-side guide layer Xpg2 [%] | 5 | 5 | 5 | 5 | 5 | 5 | 6 | 5 | 4 | 5 | 6 | 6 |
| | P-type cladding layer Xpc [%] | 10 | 10 | 10 | 10 | 10 | 10 | 10 | 10 | 10 | 10 | 10 | 10 |
| Thickness | N-side guide layer Tng [nm] | 220 | 180 | 140 | 180 | 180 | 180 | 180 | 180 | 180 | 140 | 140 | 140 |
| | First P-side guide layer Tpg1 [nm] | 40 | 56 | 72 | 56 | 56 | 56 | 56 | 56 | 56 | 72 | 72 | 72 |
| | Second P-side guide layer Tpg2 [nm] | 100 | 124 | 148 | 124 | 124 | 124 | 124 | 124 | 124 | 148 | 148 | 148 |
| Property calculation results | Optical confinement factor [%] | 5.26 | 5.26 | 4.75 | 5.20 | 5.26 | 5.26 | 6.03 | 5.26 | 4.38 | 4.75 | 5.98 | 5.94 |
| | $\Delta N$ [$10^{-3}$] | 20.80 | 23.29 | 26.50 | 19.67 | 23.29 | 25.50 | 19.83 | 23.29 | 27.96 | 26.50 | 21.60 | 18.01 |
| | Waveguide loss [cm$^{-1}$] | 6.24 | 5.71 | 6.51 | 4.99 | 5.71 | 6.17 | 4.55 | 5.71 | 6.45 | 6.51 | 4.70 | 3.93 |
| | Vertical light distribution peak position [nm] | 7.41 | 10.44 | 13.01 | 9.41 | 10.44 | 11.06 | 9.78 | 10.44 | 12.15 | 13.01 | 12.59 | 11.27 |

## FIG. 12

| Example/Comparative Example number | | C21 | C02 | C22 | C23 | C24 | C12 | C25 | C26 |
|---|---|---|---|---|---|---|---|---|---|
| Al composition ratio | N-type cladding layer Xnc [%] | 6.5 | 6.5 | 6.5 | 6.5 | 10 | 10 | 10 | 10 |
| | N-type guide layer Xng [%] | 2 | 3 | 4 | 5 | 4 | 5 | 6 | 7 |
| | Barrier layer Xb [%] | 4 | 4 | 4 | 4 | 7 | 7 | 7 | 7 |
| | First P-side guide layer Xpg1 [%] | 2 | 3 | 4 | 5 | 4 | 5 | 6 | 7 |
| | Second P-side guide layer Xpg2 [%] | 2 | 3 | 4 | 5 | 4 | 5 | 6 | 7 |
| | P-type cladding layer Xpc [%] | 6.5 | 6.5 | 6.5 | 6.5 | 10 | 10 | 10 | 10 |
| Thickness | N-side guide layer Tng [nm] | 180 | 180 | 180 | 180 | 180 | 180 | 180 | 180 |
| | First P-side guide layer Tpg1 [nm] | 56 | 56 | 56 | 56 | 56 | 56 | 56 | 56 |
| | Second P-side guide layer Tpg2 [nm] | 124 | 124 | 124 | 124 | 124 | 124 | 124 | 124 |
| Property calculation results | Optical confinement factor [%] | 5.26 | 4.87 | 3.28 | 0.96 | 5.52 | 5.26 | 4.05 | 1.46 |
| | $\Delta N$ [$10^{-3}$] | 19.5 | 20.84 | 23.6 | 30.8 | 21.8 | 23.29 | 26.1 | 33.1 |
| | Waveguide loss [$cm^{-1}$] | 3.10 | 6.19 | 25.5 | 111.6 | 3.10 | 5.71 | 25.5 | 111.6 |
| | Vertical light distribution peak position [nm] | 8.70 | 10.37 | 12.8 | 38.5 | 9.53 | 10.44 | 11.8 | 36.8 |

FIG. 13

## FIG. 14

Operating voltage [V]
(in operation at 200 mA)

Ppg2:
- ● $1 \times 10^{17}$ cm$^{-3}$
- ○ $5 \times 10^{17}$ cm$^{-3}$
- ■ $1 \times 10^{18}$ cm$^{-3}$
- □ $2 \times 10^{18}$ cm$^{-3}$
- △ $5 \times 10^{18}$ cm$^{-3}$

Thickness of first P-side guide layer [nm]

## FIG. 15

Waveguide loss
[cm$^{-1}$]

Ppg2:
- ● $1 \times 10^{17}$ cm$^{-3}$
- ○ $5 \times 10^{17}$ cm$^{-3}$
- ■ $1 \times 10^{18}$ cm$^{-3}$
- □ $2 \times 10^{18}$ cm$^{-3}$
- △ $5 \times 10^{18}$ cm$^{-3}$

Thickness of first P-side guide layer [nm]

## FIG. 16

ΔN
[10$^{-3}$]

Thickness of first P-side guide layer [nm]

## FIG. 17

Optical
confinement
factor [%]

Thickness of first P-side guide layer [nm]

# FIG. 18

# FIG. 19

## FIG. 20

## FIG. 21

## FIG. 22

## FIG. 23

FIG. 24

FIG. 25

FIG. 26

# FIG. 27

## FIG. 28

Al composition ratio x (vertical axis, 0.00–0.25)
In composition ratio y (horizontal axis, 0–0.10)

$x = 2.34y$

$x = 2.34y - 0.234$

## FIG. 29

Lattice misfit [%] (vertical axis, 0.00–0.70)
In composition ratio y (horizontal axis, 0–0.10)

## FIG. 30

## FIG. 31

FIG. 32

FIG. 33

## INTERNATIONAL SEARCH REPORT

| International application No. |
|---|
| **PCT/JP2023/003577** |

### A. CLASSIFICATION OF SUBJECT MATTER

***H01S 5/20***(2006.01)i; ***H01S 5/343***(2006.01)i
FI: H01S5/20 610; H01S5/343 610

According to International Patent Classification (IPC) or to both national classification and IPC

### B. FIELDS SEARCHED

Minimum documentation searched (classification system followed by classification symbols)

H01S5/00-5/50; H01L33/00-33/64

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2010-263163 A (SUMITOMO ELECTRIC IND LTD) 18 November 2010 (2010-11-18) paragraphs [0002], [0044]-[0089], fig. 1-4 | 1, 6, 9-14, 18 |
| Y | | 2-5, 7, 15-17 |
| A | | 8 |
| Y | JP 2017-73511 A (ASAHI KASEI CORP) 13 April 2017 (2017-04-13) paragraph [0035] | 2-5 |
| Y | JP 2011-146650 A (SUMITOMO ELECTRIC IND LTD) 28 July 2011 (2011-07-28) paragraphs [0039], [0052], [0062] | 4 |
| Y | JP 2002-335052 A (NICHIA CHEM IND LTD) 22 November 2002 (2002-11-22) paragraph [0055], fig. 4 | 7 |
| Y | JP 2010-109332 A (SANYO ELECTRIC CO LTD) 13 May 2010 (2010-05-13) paragraphs [0040], [0118], fig. 1 | 15 |
| Y | JP 2013-38394 A (ROHM CO LTD) 21 February 2013 (2013-02-21) paragraphs [0047]-[0052], [0074], fig. 1-2, 8 | 16 |

☑ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **31 March 2023** | **11 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

<table>
<tr><td>International application No.</td></tr>
<tr><td>**PCT/JP2023/003577**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| Y | JP 11-340510 A (SHARP CORP) 10 December 1999 (1999-12-10)<br>paragraphs [0041]-[0052], [0063], fig. 6 | 17 |
| A | JP 2018-517295 A (YALE UNIVERSITY) 28 June 2018 (2018-06-28)<br>entire text, all drawings | 1-18 |
| A | US 2007/0248135 A1 (MAWST, Luke J.) 25 October 2007 (2007-10-25)<br>entire text, all drawings | 1-18 |

Form PCT/ISA/210 (second sheet) (January 2015)

**INTERNATIONAL SEARCH REPORT**
Information on patent family members

International application No.

**PCT/JP2023/003577**

| Patent document cited in search report | Publication date (day/month/year) | Patent family member(s) | Publication date (day/month/year) |
|---|---|---|---|
| JP 2010-263163 A | 18 November 2010 | US 2012/0119240 A1 paragraphs [0003], [0054]-[0099], fig. 1-4<br>WO 2010/131526 A1<br>EP 2432082 A1<br>TW 201101533 A<br>CN 102422495 A<br>KR 10-2012-0024678 A | |
| JP 2017-73511 A | 13 April 2017 | (Family: none) | |
| JP 2011-146650 A | 28 July 2011 | US 2012/0061643 A1 paragraphs [0064], [0083], [0087]<br>WO 2011/087127 A1<br>EP 2528119 A1<br>CN 102473805 A<br>KR 10-2012-0023660 A<br>TW 201140879 A | |
| JP 2002-335052 A | 22 November 2002 | (Family: none) | |
| JP 2010-109332 A | 13 May 2010 | US 2010/0079359 A1 paragraphs [0047], [0124], fig. 1<br>WO 2010/035644 A1<br>CN 102171899 A | |
| JP 2013-38394 A | 21 February 2013 | US 2013/0016751 A1 paragraphs [0078]-[0085], [0110], fig. 1-2, 8 | |
| JP 11-340510 A | 10 December 1999 | (Family: none) | |
| JP 2018-517295 A | 28 June 2018 | US 2018/0152003 A1 entire text, all drawings<br>WO 2016/187421 A1<br>CN 107710381 A | |
| US 2007/0248135 A1 | 25 October 2007 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014131019 A